# EUROPEAN PATENT APPLICATION

(11) **EP 2 009 787 A1**
(43) Date of publication of application: **31.12.2008**
(21) Application number: 07738541.7
(22) Date of filing: 14.03.2007
(51) Int. Cl.: H03H 7/075, H03H 7/09

(54) **LAYERED BAND PASS FILTER**

(30) Priority: 14.04.2006 JP 2006112263; 19.07.2006 JP 2006197214
(71) Applicant: Murata Manufacturing Co. Ltd., Nagaokakyo-shi, Kyoto 617-8555 (JP)
(72) Inventor: TANIGUCHI, Tetsuo, c/o Murata Manufacturing Co., Ltd., Nagaokakyo-shi Kyoto 617-8555 (JP)
(74) Representative: Schoppe, Fritz
(86) International application number: PCT/JP2007/055071
(87) International publication number: WO 2007/119356

(57) **Abstract**

A capacitance is formed between a ground electrode (109) disposed on a ground electrode forming layer (101) and each of capacitor electrodes (111) to (115) formed on a capacitor electrode forming layer (102). A plurality of inductor electrodes are formed by via electrodes (131) to (140) and the line electrodes (116) to (120). Planes of loops of the plurality of inductor electrodes partially overlap with each other when viewed in a direction in which the inductor electrodes are arranged. In addition, the direction of the loop of the inductor electrode of an LC parallel resonator on an input side (in a first stage) is opposite to the direction of the loop of the inductor electrode of a second-stage LC parallel resonator adjacent to the inductor electrode of the LC parallel resonator on the input side. The direction of the loop of the inductor electrode of an LC parallel resonator on an output side (in a fifth stage) is opposite to the direction of the loop of the inductor electrode of a fourth-stage LC parallel resonator adjacent to the inductor electrode of the LC parallel resonator on the output side.

## Description

### Technical Field

The present invention relates to a multilayer bandpass filter including a plurality of dielectric layers and electrode layers.

### Background Art

Existing compact and low-cost high-frequency bandpass filters are formed from a plurality of LC resonators provided in a laminated structure of dielectric layers and electrode layers. Such multilayer bandpass filters are described in Patent Documents 1 to 4.

The structure of the multilayer bandpass filter disclosed in Patent Document 1 is described with reference to Fig. 1.

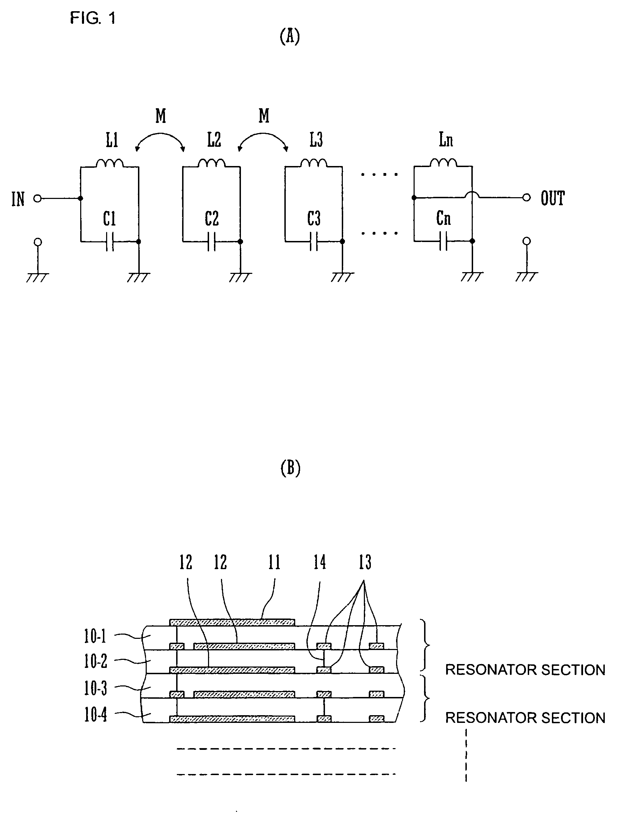

Fig. 1(A) is a circuit diagram of the multilayer bandpass filter. Fig. 1(B) is a cross-sectional view of the multilayer bandpass filter. The filter includes a plurality of inductively coupled (magnetically coupled) LC parallel resonance circuits. Coils L1, L2, L3...Ln and capacitors C1, C2, C3...Cn form the plurality of LC parallel resonators. The coils of adjacent pairs of the resonators are magnetically coupled.

As shown in Fig. 1(B), capacitor electrode patterns 12 and coil patterns 13 are formed on a first layer 10-1, a second layer 10-2, and a third layer 10-3 by printing. The resonator is formed by these layers. That is, a capacitance is formed between a ground electrode 11 and each of the capacitor electrode patterns 12. The coil patterns 13 disposed on two of the layers are conductively coupled via a blind through-hole 14. A plurality of such resonators are stacked in layers under a fourth layer 10-4 so that adjacent pairs of the coils are magnetically coupled.

In Patent Document 2, a plurality of LC resonators are formed by a plurality of capacitances formed by capacitance forming electrodes and the inductance of each of the capacitance forming electrodes in a laminated body including dielectric layers and electrode layers. In the laminated body, adjacent pairs of the LC resonators are disposed at different heights in the thickness direction of the laminated body and are electromagnetically coupled. By disposing a plurality of LC resonators in the laminated body at different heights in the thickness direction of the laminated body, the component size can be reduced while maintaining a physical distance between the LC resonators that is required for the design of a bandpass filter.

In the multilayer bandpass filter described in Patent Document 3, each of first and second filter lines includes two parallel lines and is disposed in part of an interconnection layer. The first and second filter lines are disposed in different circuit layers and face each other in parallel. An end of the first filter line is electrically connected to an end of the second filter line. In this way, a filter element is formed in which the two lines are folded via a dielectric layer.

In the multilayer bandpass filter described in Patent Document 4, two striplines of a resonator are disposed in the same layer with a predetermined spacing therebetween so as to be electromagnetically coupled.
[Patent Document 1] Japanese Unexamined Patent Application Publication No. 4-6911
[Patent Document 2] Japanese Unexamined Utility Model Registration Application Publication No. 2000-201001
[Patent Document 3] Japanese Unexamined Patent Application Publication No. 2003-198226
[Patent Document 4] International Publication Pamphlet No. 02/009225

### Disclosure of Invention

### Problems to be Solved by the Invention

In the multilayer bandpass filter described in Patent Document 1, since a coil of each of the LC parallel resonators has a double-layer coil pattern, magnetic coupling between the LC parallel resonators is disadvantageously increased. In addition, since the coil is formed by a double-layer coil pattern, the Q value of the coil deteriorates, and therefore, the insertion loss of the multilayer bandpass filter disadvantageously increases. To solve the above-described problems, the distances between pairs of the LC parallel resonators need to be sufficiently increased. Consequently, the thickness of the multilayer bandpass filter is disadvantageously increased.

In the multilayer bandpass filter described in Patent Document 2, the self-resonance of a capacitor is used. The LC parallel resonator is formed by a capacitance component of the capacitor electrode and an inductance component of the capacitor electrode. Accordingly, a resonator having desired inductance cannot be achieved, and therefore, a low-loss characteristic of the multilayer bandpass filter cannot be obtained.

In the multilayer bandpass filters described in Patent Documents 3 and 4, a compact and low-loss multilayer bandpass filter can be achieved. However, when multi-stage resonators are provided in order to obtain a steep attenuation characteristic from the passband to outside the passband, two-stage filters are stacked in the layer direction, and the striplines are coupled in the thickness direction. Accordingly, the thickness of the multilayer bandpass filter disadvantageously increases when a multi-stage filter is configured.

In addition, in such existing multilayer bandpass filters, when LC parallel resonators formed by capacitor electrodes and inductor electrodes are disposed in a laminated body so that the neighboring inductor electrodes are inductively coupled, a ripple (deviation) of a bandpass characteristic disadvantageously occurs in a passband.

Accordingly, it is an object of the present invention to provide a compact and low-loss multilayer bandpass filter having steep attenuation from the passband to the outside the passband and having low ripple in the passband. Means for Solving the Problems

### (1) ... All Embodiments

A multilayer bandpass filter includes a laminated body including a plurality of dielectric layers and a plurality of electrode layers each including at least one of a capacitor electrode and an inductor electrode, where at least three LC parallel resonators are formed by the capacitor electrodes and the inductor electrodes and pairs of the neighboring LC parallel resonators are coupled, an input electrode for allowing the LC parallel resonator disposed on an input side among the plurality of LC parallel resonators to be connected thereto, and an output electrode for allowing the LC parallel resonator disposed on an output side among the plurality of LC parallel resonators to be connected thereto. The inductor electrode of each of the plurality of LC parallel resonators forms a loop starting from a connection point between an end of the inductor electrode and the capacitor electrode, planes of the loops formed by the inductor electrodes of the coupled LC parallel resonators at least partially overlap when viewed from a direction in which the inductor electrodes are arranged, and loop directions of the inductor electrodes of the at least two coupled LC parallel resonators are opposite when viewed from a direction in which the inductor electrodes are arranged.

### (2) ... All Embodiments

The direction of the loop of the inductor electrode of the LC parallel resonator on the input side is opposite to the direction of the loop of the inductor electrode of the LC parallel resonator adjacent to the inductor electrode of the LC parallel resonator on the input side, and the direction of the loop of the inductor electrode of the LC parallel resonator on the output side is opposite to the direction of the loop of the inductor electrode of the LC parallel resonator adjacent to the inductor electrode of the LC parallel resonator on the output side.

### (3) ... Eleventh Embodiment

At least one of the plurality of LC parallel resonators includes a plurality of inductor electrodes.

### (4) ... Twelfth Embodiment

The multilayer bandpass filter further includes a traverse electrode electrically isolated from the inductor electrodes of the plurality of LC parallel resonators and extending across the inductor electrodes of the plurality of LC parallel resonators.

### (5) ... Twelfth Embodiment

The traverse electrode is connected to ground as needed.

### (6) ... All Embodiments

The multilayer bandpass filter further includes a side electrode (an electrode typically having the ground potential) provided on a side surface of the plurality of stacked dielectric layers. A ground electrode provided on a ground side of the LC parallel resonators is conductively coupled with the side electrode via at least one connection electrode.

### (7) ... Fourteenth Embodiment

The ground electrode includes a plurality of sub ground electrodes each used for predetermined ones of the plurality of LC parallel resonators, and the plurality of sub ground electrodes are electrically isolated from each other at high frequencies.

### (8) ... First to Twelfth Embodiments

The inductor electrode of each of the plurality of LC parallel resonators has the shape of a coil formed by a via electrode extending in a direction in which the dielectric layers are stacked and at least a line electrode extending in a direction that is perpendicular to the direction in which the dielectric layers are stacked, and the inductor electrodes and the capacitor electrodes are disposed in a direction that is perpendicular to the direction in which the dielectric layers and the electrode layers are stacked.

### (9) ... First, Fourth, Eighth, and Eleventh to Nineteenth Embodiments

An input and output electrode forming layer including the input electrode and the output electrode is disposed separately from an electrode layer including at least one of the capacitor electrode and the line electrode of electrodes, and the input terminal and the output terminal conductively coupled with the input electrode and the output electrode, respectively, are disposed on side surfaces of the laminated body.

### (10) ... First, Fourth, Eighth, and Eleventh to Nineteenth Embodiments

The input and output electrode forming layer is disposed between the electrode layer having the line electrodes formed therein and the electrode layer having the capacitor electrodes formed therein.

### (11)

The capacitor electrode of each of the plurality of LC parallel resonators is formed by a chip capacitor mounted on a surface of the laminated body.

### (12) ... All Embodiments except for Twenty-First Embodiment

The capacitor electrode of each of the plurality of LC parallel resonators produces a capacitance between the capacitor electrode and a common ground electrode extending over a region in which the capacitor electrodes of the plurality of LC parallel resonators are located, and the capacitor electrodes are disposed in the same electrode layer (a common electrode layer).

### (13) ... All Embodiments except for Twenty-First Embodiment

The line electrodes are disposed in the same electrode layer.

### (14) ... All Embodiments except for Twenty-First Embodiment

The line electrodes are arranged so as to be line-symmetrical with respect to an imaginary center line passing through the center of an area where the line electrodes are distributed and extending parallel to the line electrodes.

### (15) ... Eighth Embodiment

At least two neighboring line electrodes have different widths from each other.

### (16) ... Ninth and Tenth Embodiments

The distances between pairs of neighboring line electrodes are uneven in a width direction of the line electrodes.

### (17) ... Eighth Embodiment

Two via electrodes are connected to each of the line electrodes, and the distances between two connection points of at least two of the line electrodes are different.

### (18) ... Sixteenth to Eighteenth Embodiments

A capacitor electrode that capacitively couples the input electrode with the output electrode is disposed in a predetermined one of the plurality of electrode layers.

### (19) ... Twenty-Second and Twenty-Third Embodiments

At least one of the line electrodes has one of a meandering shape and a U shape.

### (20) ... Twenty-Second and Twenty-Third Embodiments

The capacitor electrodes other than the capacitor electrodes of the LC parallel resonators on the input and output sides are formed in an area other than an area located between the capacitor electrodes of the LC parallel resonators on the input and output sides.

### (21) ... Twenty-Fourth and Twenty-Fifth Embodiments

The capacitor electrodes of the LC parallel resonators on the input side and the output side are provided in an electrode layer different from an electrode layer in which the other capacitor electrodes are formed.

### (22) ... Twentieth Embodiment

The line electrodes are formed from chip inductors mounted on the surface of the laminated body.

### (23) ... All Embodiments except for Twenty-First Embodiment

The dielectric layer stacked on the electrode layer including the line electrodes has a relative permittivity greater than or equal to 6 and less than or equal to 80, and the dielectric layer having the electrode layer including the capacitor electrodes thereon has a relative permittivity greater than or equal to 20.

### (24) ... All Embodiments

The above-described dielectric layers are formed from low temperature co-fired ceramic.

### Advantages

(1) Each of inductor electrodes of a plurality of LC parallel resonators forms a loop. The planes of loops formed by the inductor electrodes of the LC parallel resonators coupled with each other at least partially overlap. Accordingly, the degree of coupling (inductive coupling) between the neighboring LC parallel resonators can be increased.
   In addition, since an inductor electrode can be formed separately from a capacitor electrode, an inductor having a high Q value can be formed, and therefore, low insertion loss can be achieved.
   Furthermore, since the resonator does not use the self-resonance of a capacitor, a resonator having desired inductance can be achieved. Thus, low insertion loss can be achieved in a desired passband.
   Still furthermore, since the directions of the loops formed by the inductor electrodes of at least two coupled LC parallel resonators are opposite, ripples of insertion loss in the passband can be reduced, and therefore, excellent bandpass characteristics can be obtained.
(2) The direction of the loop of the inductor electrode of the LC parallel resonator on the input side is opposite to the direction of the loop of the inductor electrode of the LC parallel resonator adjacent to the inductor electrode of the LC parallel resonator on the input side, and the direction of the loop of the inductor electrode of the LC parallel resonator on the output side is opposite to the direction of the loop of the inductor electrode of the LC parallel resonator adjacent to the inductor electrode of the LC parallel resonator on the output side. Accordingly, ripples of insertion loss in the passband can be further reliably reduced.
(3) The multilayer bandpass filter can further include a traverse electrode electrically isolated from the inductor electrodes of the plurality of LC parallel resonators and extending across the inductor electrodes of the plurality of LC parallel resonators. Accordingly, by simply changing the shape of the traverse electrode and the distance between the traverse electrode and the inductor electrode (the thickness of the layer), a desired passband characteristic can be obtained without changing the structure of the LC parallel resonator.
(4) By connecting the traverse electrode to ground, a bandpass filter having a characteristic different from that of a bandpass filter having a traverse electrode not connected to ground can be achieved.
(5) By providing a plurality of inductor electrodes to at least one of the plurality of LC parallel resonators, optimum inductance can be easily obtained. In addition, the degree of coupling (inductive coupling) caused by overlap between the loop planes of the inductor electrodes of the neighboring LC parallel resonators can be easily optimized.
(6) The multilayer bandpass filter can further include a side electrode provided on a side surface of the stacked dielectric layers. A ground electrode provided on a ground side of the LC parallel resonators can be conductively coupled with the side electrode via a connection electrode. At that time, the connection electrode functions as a tiny inductor. By simply changing the shape of the connection electrode (without changing the basic design structure), the passband characteristic can be changed.
(7) The ground electrode can include a plurality of sub ground electrodes electrically isolated from each other. This structure prevents an unwanted high-frequency signal from propagating in a ground electrode disposed between predetermined ones of the plurality of LC parallel resonators. Thus, the attenuation outside the passband can be increased.
(8) By arranging the inductor electrodes and the capacitor electrodes of the plurality of LC parallel resonators in a direction that is perpendicular to the direction in which the dielectric layers and the electrode layers are stacked, the distance between the loop planes of neighboring inductor electrodes can be maintained constant. Accordingly, even when misalignment in the surface direction occurs during stacking of the dielectric layers and the electrode layers, misalignment between the inductor electrodes of the neighboring LC parallel resonators can be substantially eliminated. Thus, bandpass filter characteristics with small variations can be obtained.
(9) An input and output electrode forming layer including the input electrode and the output electrode can be disposed separately from an electrode layer including at least one of the capacitor electrode and the line electrode of electrodes. Accordingly, the input terminal and the output terminal can be disposed at any location independently from the location and shape of the capacitor electrode or the inductor electrode. Consequently, the input terminal and the output terminal can be disposed at any location of the laminated body including the dielectric layers and the electrode layers.
(10) The input and output electrode forming layer can be disposed between the electrode layer having the line electrodes formed thereon and the electrode layer having the capacitor electrodes formed therein. Accordingly, variation in the resonance frequency in accordance with variations in the cutting accuracy and the accuracy of stack alignment of the layers can be reduced. That is, since the via electrodes have high positional accuracy relative to each other, the inductor electrodes have desired inductance even when locations at which the via electrodes are formed are relatively shifted due to stack misalignment of the layers or printing misalignment. Therefore, the locations at which the input terminals and the output terminals are formed do not have direct impact on the resonance frequencies of the LC parallel resonators.
(11) By forming the capacitor electrode of each of the plurality of LC parallel resonators using a chip capacitor mounted on a surface of the laminated body, the capacitance of the LC parallel resonator can be increased. In addition, since the LC parallel resonators can be coupled by using only inductive coupling, the design of the filter can be facilitated.
(12) The capacitor electrode of each of the plurality of LC parallel resonators can produce capacitance between the capacitor electrode and a common ground electrode extending over a region in which the capacitor electrodes of the plurality of LC parallel resonators are located. Accordingly, a capacitance is formed between neighboring ones of the capacitor electrodes, and therefore, the need for a capacitance element dedicated for coupling LC parallel resonator periods and required for existing multilayer bandpass filters can be eliminated. Thus, the Q value of the resonator can be improved. In addition, even when stack misalignment of the layers having the capacitor electrodes formed thereon or printing misalignment occurs, the capacitance between the capacitor electrode and the ground electrode and the capacitance between the capacitor electrode and the neighboring capacitor electrode do not vary. Thus, variations in the characteristics can be reduced.
(13) The inductor electrode of each of the plurality of LC parallel resonators can include line electrodes extending in a direction in which the dielectric layers are stacked, and the line electrodes can be disposed in the same electrode layer. In this way, variation in the inductance of each of the inductor electrodes can be reduced even when printing misalignment or stack misalignment of the line electrode forming layers, and the distance between the loop planes of the neighboring inductor electrodes can be maintained constant in high precision. Accordingly, misalignment between the inductor electrodes of two neighboring LC parallel resonators can be substantially eliminated. Thus, bandpass filter characteristics with small variations can be obtained.
(14) The line electrodes can be arranged so as to be line-symmetrical with respect to an imaginary center line passing through the center of an area where the line electrodes are distributed and extending parallel to the line electrodes. In this way, the directivity of the input and output can be eliminated. Accordingly, even when the filter is mounted on a mounting substrate in both orientations, the same electrical characteristic can be obtained.
(15) At least two neighboring line electrodes can have different widths from each other. In this way, each of the inductance values of the inductors of the LC parallel resonators can be fine-adjusted.
(16) Similarly, the distances between pairs of neighboring line electrodes can be uneven in a width direction of the line electrodes. In this way, electromagnetic field coupling between the LC parallel resonators can be changed. Thus, the input and output impedance can be controlled.
(17) Two via electrodes can be connected to each of the line electrodes, and the distances between two connection points of at least two of the line electrodes can be different. In this way, the resonance frequency of each of the LC parallel resonators can be fine-adjusted. Thus, ripples in the passband can be minimized.
(18) By forming the line electrodes using chip inductors mounted on the surface of the laminated body, an inductor having a high inductance value can be achieved. In addition, by changing the chip inductors, a desired attenuation characteristic can be obtained.
(19) At least one of the plurality of line electrodes can have one of a meandering shape and a U shape. In this way, a relatively long line electrode can be formed in a limited area. Therefore, an area required for obtaining necessary inductance can be reduced, and thus, the overall size can be reduced.
(20) The capacitor electrodes other than the capacitor electrodes of the LC parallel resonators on the input and output sides can be formed in an area other than an area located between the capacitor electrodes of the LC parallel resonators on the input and output sides. In this way, the capacitance formed between the capacitor electrode of the LC parallel resonator on the input side and the capacitor electrode of the LC parallel resonator on the output side can be set without being influenced by the other capacitor electrodes. Since unwanted coupling does not occur, the frequency design of the attenuation poles on either side of the passband can be facilitated.
(21) By changing the capacitance between the input electrode and the output electrode, the frequency of the attenuation pole appearing on at least one side of the attenuation band of the filter can be changed, and therefore, the attenuation characteristic of the filter can controlled. However, if another electrode is present between the input electrode and the output electrode, capacitance control needs to be performed using the electrode. Accordingly, it is difficult to control the capacitance value. By disposing the capacitor electrodes of the LC parallel resonators on the input side and the output side and the other capacitor electrodes in different layers, these capacitors are not coupled with the capacitor electrode of the other resonators. Thus, stable capacitance can be obtained. As a result, the attenuation pole characteristic and the filter characteristic can be improved. Furthermore, since the capacitance can be controlled only by the distance between the input electrode and the output electrode, frequency control (frequency setting) of the attenuation pole can be facilitated.
(22) By providing an additional capacitor electrode in order to connect the input electrode to the output electrode using capacitance, a desired attenuation characteristic can be obtained without changing the basic structure of the LC parallel resonator.
(23) By setting the relative dielectric constant of the dielectric layer stacked on the electrode layer including the line electrodes to a value greater than or equal to 6 and less than or equal to 80 and setting the relative dielectric constant of the dielectric layer having the electrode layer including the capacitor electrodes thereon to a value greater than or equal to 20, the capacitance per unit area can be increased. Accordingly, the overall size can be reduced. In addition, deterioration of the Q value of the inductor can be reduced.
(24) By forming the dielectric layers using low temperature co-fired ceramic, the capacitance per unit area can be increased. Accordingly, the overall size can be reduced.

### Brief Description of Drawings

[Fig. 1] Fig. 1 is an equivalent circuit diagram and a cross-sectional view of a multilayer bandpass filter described in Patent Document 1.
[Fig. 2] Fig. 2 is an exploded perspective view and an external perspective view of a multilayer bandpass filter according to a first embodiment.
[Fig. 3] Fig. 3 is an equivalent circuit diagram and a bandpass characteristic diagram of the filter.
[Fig. 4] Fig. 4 is an exploded perspective view of a multilayer bandpass filter according to a second embodiment.
[Fig. 5] Fig. 5 is an equivalent circuit diagram of a multilayer bandpass filter according to a third embodiment.
[Fig. 6] Fig. 6 is a bandpass characteristic diagram of the filter when the polarity sequence of coupling between pairs of neighboring LC parallel resonators is <101>.
[Fig. 7] Fig. 7 is a bandpass characteristic diagram of the filter when the polarity sequence of coupling between pairs of neighboring LC parallel resonators is changed to <111>.
[Fig. 8] Fig. 8 is a bandpass characteristic diagram when the polarity sequence of coupling between pairs of neighboring LC parallel resonators is changed to <111> and the filter is designed so that a desirable passband is obtained.
[Fig. 9] Fig. 9 is a bandpass characteristic diagram of the filter when the polarity sequence of coupling between pairs of neighboring LC parallel resonators is <110>.
[Fig. 10] Fig. 10 is an exploded perspective view of a multilayer bandpass filter according to a fourth embodiment.
[Fig. 11] Fig. 11 is an external perspective view of the filter.
[Fig. 12] Fig. 12 is an exploded perspective view of a multilayer bandpass filter according to a fifth embodiment.
[Fig. 13] Fig. 13 is an equivalent circuit diagram of the filter.
[Fig. 14] Fig. 14 is an exploded perspective view of a multilayer bandpass filter according to a sixth embodiment.
[Fig. 15] Fig. 15 is an external perspective view of the filter.
[Fig. 16] Fig. 16 is an exploded perspective view of a multilayer bandpass filter according to a seventh embodiment.
[Fig. 17] Fig. 17 is an equivalent circuit diagram of the filter.
[Fig. 18] Fig. 18 is an exploded perspective view of a multilayer bandpass filter according to an eighth embodiment.
[Fig. 19] Fig. 19 is a plan view of a line electrode forming layer of the filter.
[Fig. 20] Fig. 20 illustrates three examples in which the dimensions of elements of a line electrode are changed.
[Fig. 21] Fig. 21 illustrates characteristic diagrams of the three multilayer bandpass filters shown in Fig. 20.
[Fig. 22] Fig. 22 is a plan view of a line electrode forming layer of a multilayer bandpass filter according to a ninth embodiment.
[Fig. 23] Fig. 23 illustrates four examples in which the dimensions of elements of a line electrode of the filter are changed.
[Fig. 24] Fig. 24 illustrates bandpass characteristic diagrams of the four multilayer bandpass filters shown in Fig. 23.
[Fig. 25] Fig. 25 is a plan view of a line electrode forming layer of a multilayer bandpass filter according to a tenth embodiment.
[Fig. 26] Fig. 26 illustrates seven examples in which the dimensions of elements of a line electrode of the filter are changed.
[Fig. 27] Fig. 27 illustrates bandpass characteristic diagrams of the seven multilayer bandpass filters shown in Fig. 26.
[Fig. 28] Fig. 28 is an exploded perspective view of a multilayer bandpass filter according to an eleventh embodiment.
[Fig. 29] Fig. 29 is an exploded perspective view of a multilayer bandpass filter according to a twelfth embodiment.
[Fig. 30] Fig. 30 is a bandpass characteristic diagram of the filter.
[Fig. 31] Fig. 31 is an exploded perspective view of another multilayer bandpass filter according to the twelfth embodiment.
[Fig. 32] Fig. 32 is a bandpass characteristic diagram of a multilayer bandpass filter having no traverse electrode according to the twelfth embodiment.
[Fig. 33] Fig. 32 is a bandpass characteristic diagram of a multilayer bandpass filter having an ungrounded traverse electrode according to the twelfth embodiment.
[Fig. 34] Fig. 34 is a bandpass characteristic diagram of a multilayer bandpass filter having a grounded traverse electrode according to the twelfth embodiment.
[Fig. 35] Fig. 35 is an exploded perspective view of a multilayer bandpass filter according to a thirteenth embodiment.
[Fig. 36] Fig. 36 is an equivalent circuit diagram of the filter.
[Fig. 37] Fig. 37 is a bandpass characteristic diagram of the filter.
[Fig. 38] Fig. 38 is an exploded perspective view of a multilayer bandpass filter according to a fourteenth embodiment.
[Fig. 39] Fig. 39 is an equivalent circuit diagram of the filter.
[Fig. 40] Fig. 40 is an exploded perspective view of a multilayer bandpass filter according to a fifteenth embodiment.
[Fig. 41] Fig. 41 is an equivalent circuit diagram of the filter.
[Fig. 42] Fig. 42 is an exploded perspective view of a multilayer bandpass filter according to a sixteenth embodiment.
[Fig. 43] Fig. 43 is an equivalent circuit diagram and a bandpass characteristic diagram of the filter.
[Fig. 44] Fig. 44 illustrates comparative examples of an equivalent circuit diagram and a bandpass characteristic diagram of a multilayer bandpass filter according to the sixteenth embodiment.
[Fig. 45] Fig. 45 is an exploded perspective view of a multilayer bandpass filter according to a seventeenth embodiment.
[Fig. 46] Fig. 46 is an equivalent circuit diagram and a bandpass characteristic diagram of the filter.
[Fig. 47] Fig. 47 illustrates comparative examples of an equivalent circuit diagram and a bandpass characteristic diagram of a multilayer bandpass filter according to the seventeenth embodiment.
[Fig. 48] Fig. 48 is an exploded perspective view of a multilayer bandpass filter according to an eighteenth embodiment.
[Fig. 49] Fig. 49 is an equivalent circuit diagram of the filter.
[Fig. 50] Fig. 50 is an exploded perspective view of a multilayer bandpass filter according to a nineteenth embodiment.
[Fig. 51] Fig. 51 is an exploded perspective view and an external perspective view of a multilayer bandpass filter according to a twentieth embodiment.
[Fig. 52] Fig. 52 is an exploded perspective view of a multilayer bandpass filter according to a twenty-first embodiment.
[Fig. 53] Fig. 53 is an equivalent circuit diagram of the filter.
[Fig. 54] Fig. 54 is an exploded perspective view of a multilayer bandpass filter according to a twenty-second embodiment.
[Fig. 55] Fig. 55 is an equivalent circuit diagram and a characteristic diagram of the filter.
[Fig. 56] Fig. 56 is an exploded perspective view of a multilayer bandpass filter according to a twenty-third embodiment.
[Fig. 57] Fig. 57 is an exploded perspective view of a multilayer bandpass filter according to a twenty-fourth embodiment.
[Fig. 58] Fig. 58 is an equivalent circuit diagram and a characteristic diagram of the filter.
[Fig. 59] Fig. 57 is an exploded perspective view of a multilayer bandpass filter according to a twenty-fifth embodiment.
[Fig. 60] Fig. 60 is an equivalent circuit diagram and a characteristic diagram of the filter.

### Reference Numerals

1 - 4 multilayer bandpass filter
6 ground terminal
7, 8 input and output terminal
101, 201, 301 ... 901, 1001 ground electrode forming layer
102, 202, 302, 402, 902, 1002, 1006 capacitor electrode forming layer
103, 203, 303 ... 603, 903, 1003 input and output electrode forming layer
104, 204, 304 ... 504, 904, 1004 line electrode forming layer
105, 305, 405, 905, 1005 outer layer
106 traverse electrode forming layer
109, 209 - 211, 309, 409, 509, 1009 ground electrode
111 - 115, 311 - 313, 411 - 414, 1011 - 1014 capacitor electrode
116 - 120, 216 - 220, 316 - 319, 416, 418, 420, 516 - 518, 616 - 619, 1016 - 1019 line electrode
121, 221, 321 ... 821, 1021, 1022input and output electrode
122, 222, 322 ... 722, 821 - 824 input and output electrode
131 - 140, 231 - 240, 331 - 336, 431 - 438, 1031 - 1038 via electrode
141, 241, 341, 441 input-and-output-section via electrode
142, 342, 442 input-and-output-section via electrode
151, 152, 153, 154, 155 - 158, 251 - 256, 351, 352, 451, 452, 551 ground connection electrode
L1 - L5 inductor
C1 - C5 capacitor
C12, C23, C34, C45 coupling capacitance
M1 - M4 inductive coupling
100, 200, 300 laminated body
160, 260, 360, 460, 1060 input-output intermediate capacitor electrode
170 traverse electrode
171 - 175 chip inductor
507, 607 input-output intermediate capacitor electrode forming layer
(716A, 716B) - (720A, 720B) chip-inductor connection electrode
21, 23, 25, 27 ground electrode forming layer
22, 24, 26 inductor and capacitor electrode forming layers
28 outer layer
33 - 34 ground electrode
41 - 43 capacitor electrode
51 - 53 inductor electrode
60, 61 ground terminal
71 - 76 ground connection electrode
81, 82 input and output terminal
91 - 93 via electrode

### Best Modes for Carrying Out the Invention

### First Embodiment

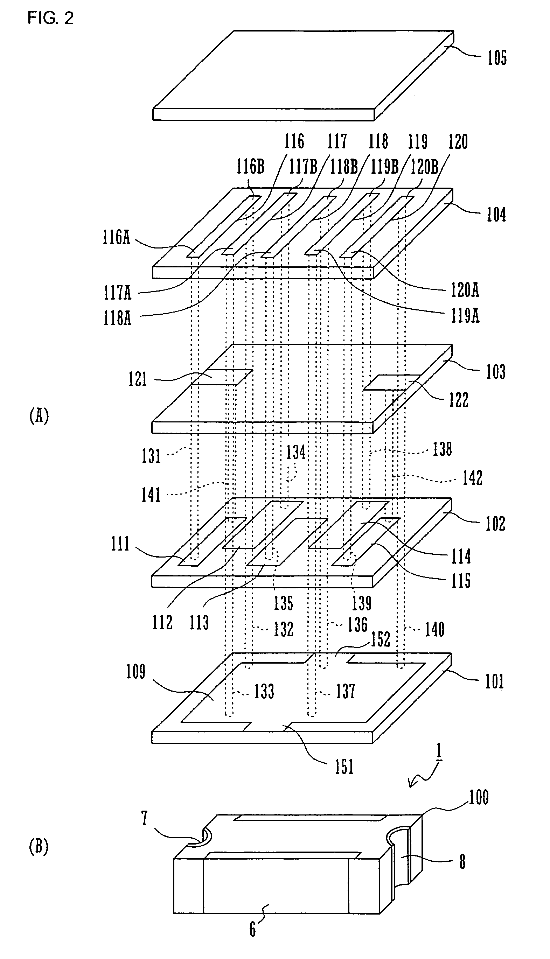

A multilayer bandpass filter according to a first embodiment is described with reference to Figs. 2 to 9.

Fig. 2(A) is an exploded perspective view of the multilayer bandpass filter according to the first embodiment. Fig. 2(B) is an external perspective view of the multilayer bandpass filter.

As shown in Fig. 2(A), the multilayer bandpass filter includes a ground electrode forming layer 101, a capacitor electrode forming layer 102, an input and output electrode forming layer 103, a line electrode forming layer 104, and an outer layer 105. Each of these layers includes an electrode having a predetermined pattern formed on a dielectric layer. By laminating these layers, a laminated body including dielectric layers and electrode layers is formed.

In Fig. 2(A), a ground electrode 109 is formed on the upper surface of the ground electrode forming layer 101. Capacitor electrodes 111 to 115 are formed on the capacitor electrode forming layer 102. Input and output electrodes 121 and 122 are formed on the input and output electrode forming layer 103. Line electrodes 116 to 120 are formed on the line electrode forming layer 104. This multilayer bandpass filter has a laminated body including five dielectric layers and four electrode layers. The multilayer bandpass filter further includes terminal electrodes formed on the end surfaces of the laminated body.

In Fig. 2(B), a laminated body 100 includes the above-described laminated dielectric layers and electrode layers. Input and output terminals 7 and 8 are disposed on two opposing side surfaces (end surfaces) of the four side surfaces of the laminated body 100. Ground terminals 6 are disposed on the other two side surfaces. Thus, a multilayer bandpass filter 1 is formed.

The dielectric layers of the above-described layers are formed from low temperature co-fired ceramic (LTCC) having a relative permittivity in the range of 6 to 80.

In addition, the dielectric layers stacked on the electrode layer including the line electrodes, that is, the line electrode forming layer 104 and the outer layer 105 have a relative permittivity in the range of 6 to 80. Furthermore, the capacitor electrode forming layer has a relative permittivity higher than and equal to 20. The dielectric layers are formed from a low temperature co-fired ceramic including, for example, a glass component and at least one of titanium oxide, barium oxide, and alumina components.

The materials for forming the dielectric layers are similarly applied to all the following embodiments.

As shown in Fig. 2(A), the ground electrode 109 and ground connection electrodes 151 and 152 are formed on the ground electrode forming layer 101. The ground electrode 109 occupies an area slightly smaller than the planar shape of the ground electrode forming layer 101. The ground connection electrodes 151 and 152 are conductively coupled with and extend from the ground electrode 109 to the two side surfaces of the ground electrode forming layer 101. The two ground connection electrodes 151 and 152 are conductively coupled with the ground terminals 6 shown in Fig. 2(B).

The five capacitor electrodes 111 to 115 having a rectangular shape are formed on the capacitor electrode forming layer 102 so as to be parallel to each other. A capacitance is formed between each of the capacitor electrodes 111 to 115 and the ground electrode 109. In addition, a capacitance is formed between the pairs of the adjacent capacitor electrodes 111 to 115.

The input and output electrodes 121 and 122 having a rectangular shape are formed on the input and output electrode forming layer 103 so as to be in contact with the short sides of the input and output electrode forming layer 103. The two input and output electrodes 121 and 122 are conductively coupled with the input and output terminals 7 and 8 shown in Fig. 2(B), respectively.

The line electrodes 116 to 120 having a line shape are formed on the line electrode forming layer 104 so as to be parallel to each other.

Via electrodes 131 to 142 are formed in the capacitor electrode forming layer 102, the input and output electrode forming layer 103, and the line electrode forming layer 104 so as to extend in the layer direction. The via electrode 131 is conductively coupled with one end 116A of the line electrode 116 and the capacitor electrode 111. The via electrode 132 is conductively coupled with the other end 116B of the line electrode 116 and the ground electrode 109. The via electrode 133 is conductively coupled with one end 117A of the line electrode 117 and the ground electrode 109. The via electrode 134 is conductively coupled with the other end 117B of the line electrode 117 and the capacitor electrode 112. The via electrode 135 is conductively coupled with one end 118A of the line electrode 118 and the capacitor electrode 113. The via electrode 136 is conductively coupled with the other end 118B of the line electrode 118 and the ground electrode 109. The via electrode 137 is conductively coupled with one end 119A of the line electrode 119 and the ground electrode 109. The via electrode 138 is conductively coupled with the other end 119B of the line electrode 119 and the capacitor electrode 114. The via electrode 139 is conductively coupled with one end 120A of the line electrode 120 and the capacitor electrode 115. The via electrode 140 is conductively coupled with the other end 120B of the line electrode 120 and the ground electrode 109.

Accordingly, inductor electrodes formed by the via electrodes and the line electrodes and the loop direction of the inductor electrodes are as follows:

**TABLE 1**

| Inductor Electrode | Via Electrode | Line Electrode | Loop Direction |
|---|---|---|---|
| First electrode | 131, 132 | 116 | 1 |
| Second electrode | 133, 134 | 117 | 0 |
| Third electrode | 135, 136 | 118 | 1 |
| Fourth electrode | 137, 138 | 119 | 0 |
| Fifth electrode | 139, 140 | 120 | 1 |

The term "loop" formed by the inductor electrode refers to a path of the inductor electrode starting from a connection point between the capacitor electrode and the inductor electrode. That is, the loop is formed from a connection path starting from a connection point between the capacitor electrode and the inductor electrode to the via electrode, to the line electrode, and to another via electrode.

The term "direction of loop" refers to a rotational direction from the start point of the loop when viewed from one of arrangement directions of the line electrodes. For example, in Fig. 2(A), when loops formed by the inductor electrodes are viewed from the side of the input and output electrode 121 to the side of the input and output electrode 122, a loop formed by the first inductor electrode is a connection path starting from a connection point between the capacitor electrode 111 and the via electrode 131 (a start point) to the via electrode 131, to the line electrode 116, and to the via electrode 132. The direction of the loop formed by the first inductor electrode is counterclockwise. A loop formed by the second inductor electrode is a connection path starting from a connection point between the capacitor electrode 112 and the via electrode 134 (a start point) to the via electrode 134, to the line electrode 117, and to the via electrode 133. The direction of the loop formed by the second inductor electrode is clockwise. The loop has only two directions: counterclockwise and clockwise. Accordingly, one of the directions is indicated by "1", and the other is indicated by "0".

The polarity sequence of coupling between the five (five-stage) LC parallel resonators shown in Table 1 from the input side to the output side of the bandpass filter can be expressed as <10101>.

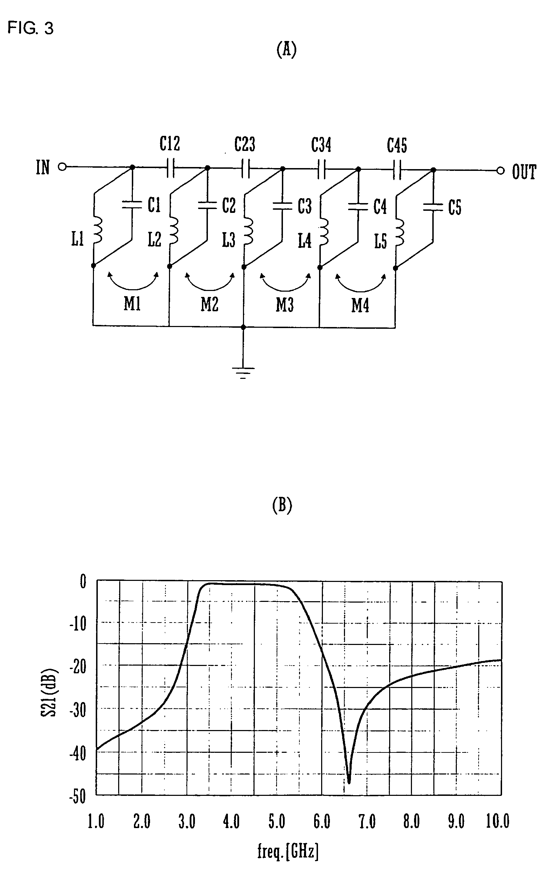

In addition, an input-and-output-section via electrode 141 is conductively coupled with the input and output electrode 121 and the capacitor electrode 111. The input-and-output-section via electrode 142 is conductively coupled with the input and output electrode 122 and the capacitor electrode 115. Fig. 3(A) is an equivalent circuit diagram of the multilayer bandpass filter. Fig. 3(B) illustrates the bandpass characteristic (the S21 characteristic of the S-parameter) of the multilayer bandpass filter.

In Fig. 3(A), an input terminal IN corresponds to the input and output terminal 7 conductively coupled with the input and output electrode 121 shown in Fig. 2(A). An output terminal OUT corresponds to the input and output terminal 8 conductively coupled with the input and output electrode 122. An inductor L1 represents inductance produced by the inductor electrode formed by the via electrodes 131 and 132 and the line electrode 116. An inductor L2 represents inductance produced by the inductor electrode formed by the via electrodes 133 and 134 and the line electrode 117. Similarly, an inductor L3 represents an inductance component produced by the inductor electrode formed by the via electrodes 135 and 136 and the line electrode 118. An inductor L4 represents an inductance component produced by the inductor electrode formed by the via electrodes 137 and 138 and the line electrode 119. An inductor L5 represents an inductance component produced by the inductor electrode formed by the via electrodes 139 and 140 and the line electrode 120.

In addition, capacitors C1 to C5 are capacitors having capacitances formed between the capacitor electrodes 111 to 115 and the ground electrode 109, respectively. A capacitor C12 is a capacitor having a capacitance produced between the capacitor electrodes 111 and 112. Similarly, a capacitor C23 is a capacitor having a capacitance produced between the capacitor electrodes 112 and 113. A capacitor C34 is a capacitor having a capacitance produced between the capacitor electrodes 113 and 114. A capacitor C45 is a capacitor having a capacitance produced between the capacitor electrodes 114 and 115.

In this way, when the plane of a loop formed by an inductor electrode formed by two via electrodes and one line electrode is viewed from the arrangement direction of the inductor electrodes, the planes of the loops at least partially overlap. Therefore, at least two inductors formed by neighboring inductor electrodes are inductively coupled.

As shown in Fig. 3(B), in this example, bandpass filter characteristics having a passband of 3.3 to 5.3 GHz and a stopband of the other frequency range can be obtained. In addition, an attenuation pole occurs at 6.6 GHz, and therefore, large attenuation can be obtained in the range around the attenuation pole. The attenuation pole is generated by inductively coupling a plurality of LC parallel resonators using alternately reversed polarities.

### Second Embodiment

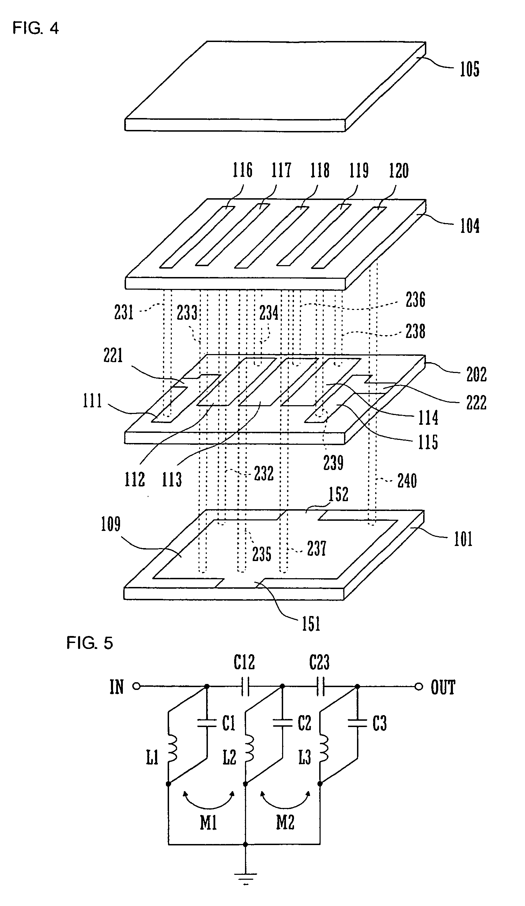

Fig. 4 is an exploded perspective view of a multilayer bandpass filter according to a second embodiment. Fig. 4 corresponds to Fig. 2(A) of the first embodiment for a comparison purpose. Accordingly, similar numbering will be used for components similar to those of the first embodiment.

A method for leading out the input electrode and the output electrode and the polarity sequence of inductive coupling between adjacent LC parallel resonators are different from those of the first embodiment.

The multilayer bandpass filter has a laminated body including a ground electrode forming layer 101, a capacitor electrode forming layer 202, a line electrode forming layer 104, and an outer layer 105.

A ground electrode 109 and ground connection electrodes 151 and 152 are formed on the ground electrode forming layer 101. Five capacitor electrodes 111 to 115 are formed on the capacitor electrode forming layer 202. Input and output electrodes 221 and 222 are formed on the capacitor electrode forming layer 202. The input and output electrodes 221 and 222 are conductively coupled with the capacitor electrodes 111 and 115, respectively, and are led out to either end portion of the capacitor electrode forming layer 202. Five line electrodes 116 to 120 are formed on the line electrode forming layer 104.

The via electrode 231 is conductively coupled with the capacitor electrode 111 and one end of the line electrode 116. The via electrode 232 is conductively coupled with the other end of the line electrode 116 and the ground electrode 109. The via electrode 233 is conductively coupled with the ground electrode 109 and one end of the line electrode 117. The via electrode 234 is conductively coupled with the other end of the line electrode 117 and the capacitor electrode 112. The via electrode 235 is conductively coupled with the ground electrode 109 and one end of the line electrode 118. The via electrode 236 is conductively coupled with the other end of the line electrode 118 and the capacitor electrode 113. The via electrode 237 is conductively coupled with the ground electrode 109 and one end of the line electrode 119. The via electrode 238 is conductively coupled with the other end of the line electrode 119 and the capacitor electrode 114. The via electrode 239 is conductively coupled with one end of the line electrode 120 and the capacitor electrode 115. The via electrode 240 is conductively coupled with the other end of the line electrode 120 and the ground electrode 109.

Accordingly, inductor electrodes formed by the via electrodes and the line electrodes and the directions of the loops thereof are as follows:

**TABLE 2**

| Inductor Electrode | Via Electrode | Line Electrode | Loop Direction |
|---|---|---|---|
| First electrode | 231, 232 | 116 | 1 |
| Second electrode | 233, 234 | 117 | 0 |
| Third electrode | 235, 236 | 118 | 0 |
| Fourth electrode | 237, 238 | 119 | 0 |
| Fifth electrode | 239, 240 | 120 | 1 |

As described above, the direction of the loop formed by an inductor electrode (a first inductor electrode) of the input-side LC parallel resonator is opposite to the direction of the loop formed by an inductor electrode (a second electrode) neighboring the first inductor electrode of the LC parallel resonator. In addition, the direction of the loop formed by an inductor electrode (a fifth inductor electrode) of the output-side LC parallel resonator is opposite to the direction of the loop formed by an inductor electrode (a fourth electrode) neighboring the fifth inductor electrode of the LC parallel resonator. The direction of the loop formed by a third inductor electrode is the same as the directions of the loops formed by the second and fourth inductor electrodes. Therefore, the polarity sequence of coupling between the LC parallel resonators of the bandpass filter can be represented as <10001>.

As described above, by reversing the directions of the loops formed by the inductor electrodes of neighboring LC parallel resonators and, in particular, by reversing the directions of the loops formed by the inductor electrodes of the input-side or output-side LC parallel resonator and the LC parallel resonator adjacent to the LC parallel resonator, the ripple in the passband can be reduced.

### Third Embodiment

A multilayer bandpass filter according to a third embodiment is described with reference to Figs. 5 to 9.

According to the third embodiment, the multilayer bandpass filter includes three LC parallel resonators. The equivalent circuit diagram of the multilayer bandpass filter is shown in Fig. 5. In the first and second embodiments, five (five-stage) LC parallel resonators are coupled. Similarly, an inductor electrode in each stage can be formed by two via electrodes and one line electrode.

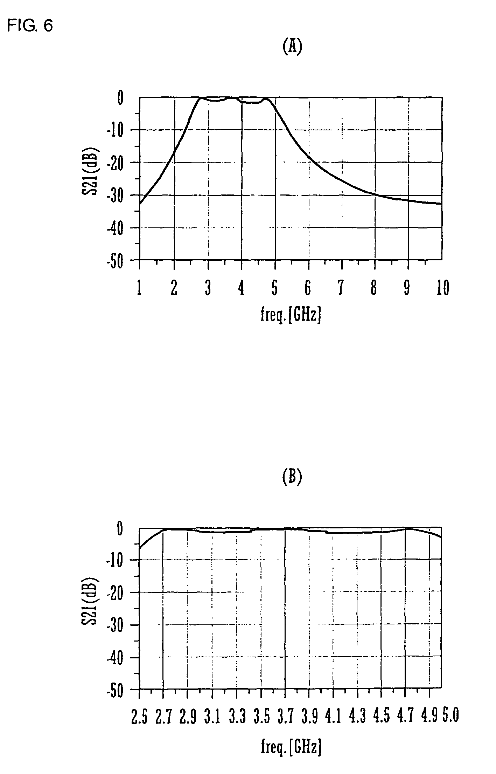

Figs. 6 to 9 illustrate differences in the characteristics of such a three-stage multilayer bandpass filter when the polarity of inductive coupling between neighboring LC parallel resonators, that is, the direction of the loop formed by an inductor electrode is changed. That is, Figs. 6 to 9 illustrate the bandpass characteristic (S21 characteristic of the S-parameter), where Figs. 6(A),...,9(A) illustrate the characteristics in the frequency range including the passband and the attenuation range above and below the passband, and Figs. 6(B),...,9(B) illustrate the characteristic in, in particular, the passband.

Fig. 6 illustrates the characteristics when the three (three-stage) LC parallel resonators are coupled so as to have a polarity sequence of <101>, that is, when the input-side LC parallel resonator is inductively coupled with the second-stage input-side LC parallel resonator using opposite polarities, and the second-stage LC parallel resonator is inductively coupled with the output-side LC parallel resonator using opposite polarities. In this case, a low-ripple bandpass characteristic can be obtained in the passband of 2.7 to 4.8 GHz.

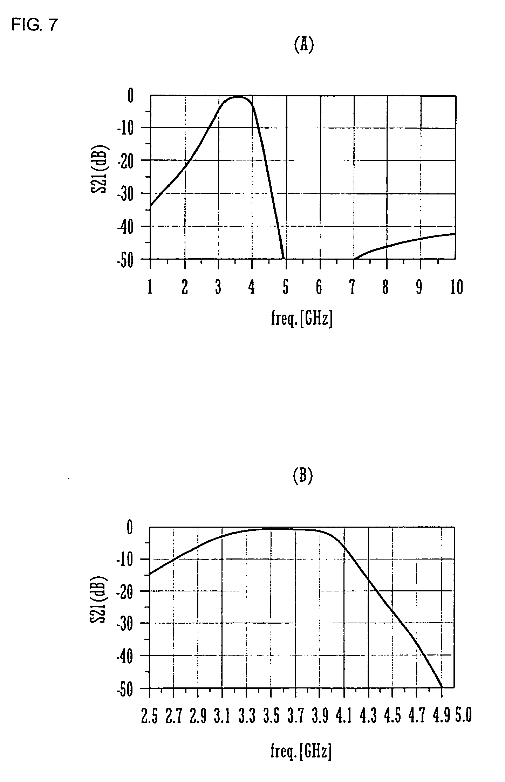

Fig. 7 illustrates the characteristics when only the same polarity of coupling (<111>) is provided without changing the inductance of the inductor electrodes and the capacitance of the capacitor electrodes that provide the characteristics shown in Fig. 6. As can be seen from Fig. 7, the passband is decreased to the range of 3.2 to 4.0 GHz.

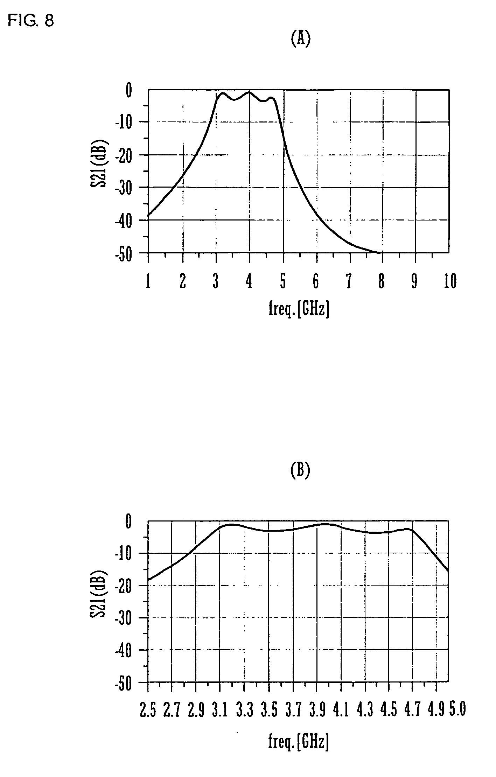

Fig. 8 illustrates the characteristics when the inductance and the capacitance of the three LC parallel resonators are adjusted so that the passband ranges from 3.0 to 4.8 GHz under the condition in which the polarity sequence of coupling between the three (three-stage) LC parallel resonators is <111>.

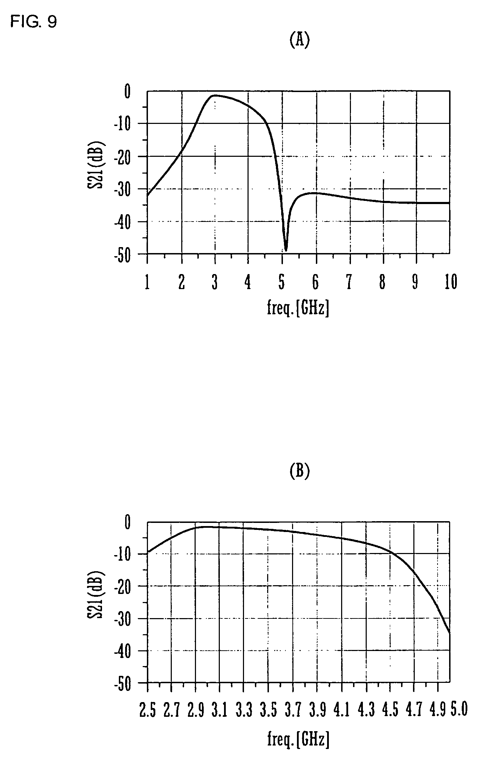

Fig. 9 illustrates the characteristics when the polarity sequence of coupling between the three (three-stage) LC parallel resonators is <110>. Compared with the case of the polarity sequence <101> shown in Fig. 6, an attenuation pole appears in the high-frequency region of the passband, and therefore, a wide passband characteristic cannot be obtained. However, a sufficiently wide frequency range and attenuation that can maintain a low insertion loss can be obtained.

As described above, by setting the directions of the loops formed by the inductor electrodes of the two LC parallel resonators to be coupled to be opposite, a low-insertion loss characteristic can be obtained over a wide frequency range.

### Fourth Embodiment

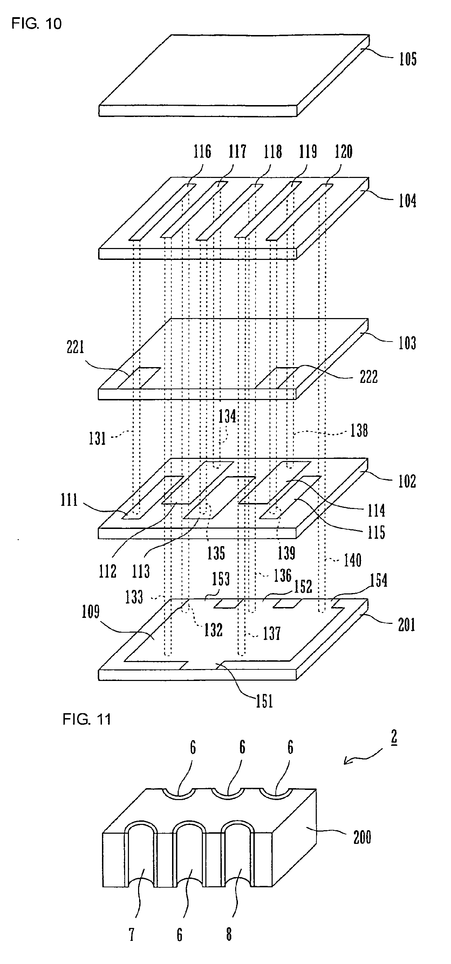

Fig. 10 is an exploded perspective view of a multilayer bandpass filter according to a fourth embodiment. Fig. 11 is an external perspective view of the multilayer bandpass filter.

The positions of an input and output electrodes, ground connection electrodes, input and output terminals, and ground terminals are different from those of the multilayer bandpass filter of the first embodiment shown in Fig. 2.

For comparison, similar numbering will be used in describing Fig. 10 as was utilized above in describing Fig. 2(A). The multilayer bandpass filter has a laminated body 200 including a ground electrode forming layer 201, a capacitor electrode forming layer 102, an input and output electrode forming layer 103, a line electrode forming layer 104, and an outer layer 105. The laminated body 200 further includes input and output terminals and a ground terminal.

A ground electrode 109 and ground connection electrodes 151 to 154 are formed on the ground electrode forming layer 201. The ground connection electrode 151 of these ground connection electrodes is led out to the middle section of one of the long sides of the ground electrode forming layer 201. The other three ground connection electrodes 152 to 154 are led out to the other long side. Capacitor electrodes 111 to 115 are formed on the capacitor electrode forming layer 102. Input and output electrodes 221 and 222 are formed on the input and output electrode forming layer 103. In the example shown in Fig. 2(A), two input and output electrodes are led out to the end edges of the input and output electrode forming layer 103. However, in the example shown in Fig. 10, the input and output electrodes 221 and 222 are led out to the same long side section. Line electrodes 116 to 120 are formed on the line electrode forming layer 104.

A via electrode 131 is conductively coupled with a capacitor electrode 111 and an end of a line electrode 116. In addition, the middle of the via electrode 131 is conductively coupled with the input and output electrodes 221. A via electrode 139 is conductively coupled with a capacitor electrode 115 and an end of a line electrode 120. In addition, the middle of the via electrode 139 is conductively coupled with the input and output electrode 222.

Unlike the equivalent circuit diagram shown in Fig. 3(A), in the equivalent circuit diagram of the multilayer bandpass filter according to the fourth embodiment, an input terminal IN is connected to the middle section of an inductor L1, and an output terminal OUT is connected to the middle section of an inductor L5.

According to such a structure, since the ground connection electrode 151 and one of the ground terminals 6 are located between the two input and output electrodes 221 and 222 and between the two input and output terminals 7 and 8, unwanted bypass between an input signal and an output signal can be blocked. In addition, since each of the input and output terminals is conductively coupled with the via terminal that connects the capacitor electrode to the line electrode, the position of the inductor electrode from which the input and output terminal is led out can be freely changed by changing the thickness of the input and output electrode forming layer. In this way, a desired input and output impedance can be obtained.

### Fifth Embodiment

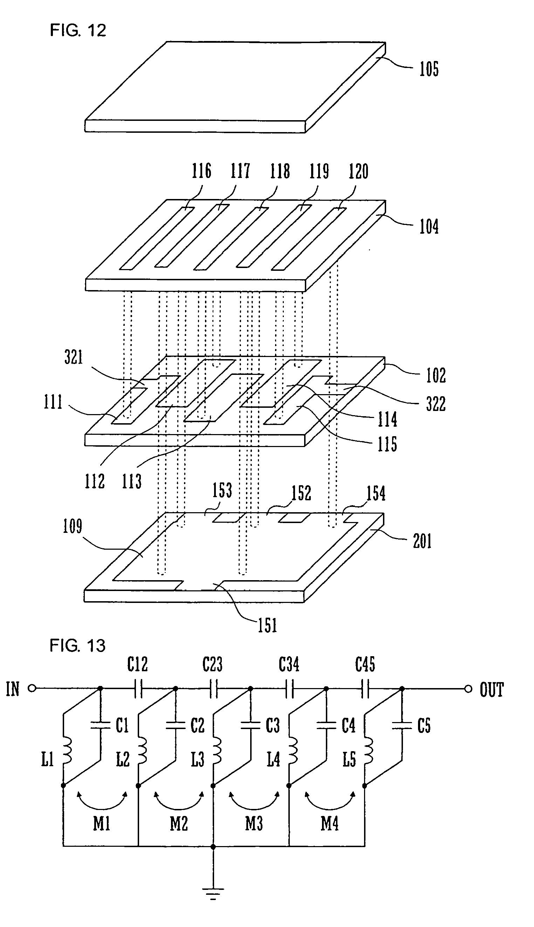

Fig. 12 is an exploded perspective view of a multilayer bandpass filter according to a fifth embodiment. Fig. 13 is an equivalent circuit diagram of the multilayer bandpass filter.

In this embodiment, four ground connection electrodes 151 to 154 are led out from the ground electrode 109. In addition, capacitor electrodes 111 to 115 are formed on a capacitor electrode forming layer 102. Furthermore, input and output terminals 321 and 322 are formed on the capacitor electrode forming layer 102 so as to be conductively coupled with the capacitor electrodes 111 and 115, respectively. Accordingly, a layer corresponding to the input and output electrode forming layer 103 shown in Fig. 2(A) is not present. The other structures are similar to those of the first embodiment.

The equivalent circuit diagram shown in Fig. 13 is similar to that shown in Fig. 3(A). However, in the structure shown in Fig. 2(A), the input-and-output-section via electrode 141 and 142 are provided between the input and output electrode 121 and the capacitor electrode 111 and between the input and output electrode 122 and the capacitor electrode 115, respectively. Accordingly, the electrical characteristics are slightly different.

### Sixth Embodiment

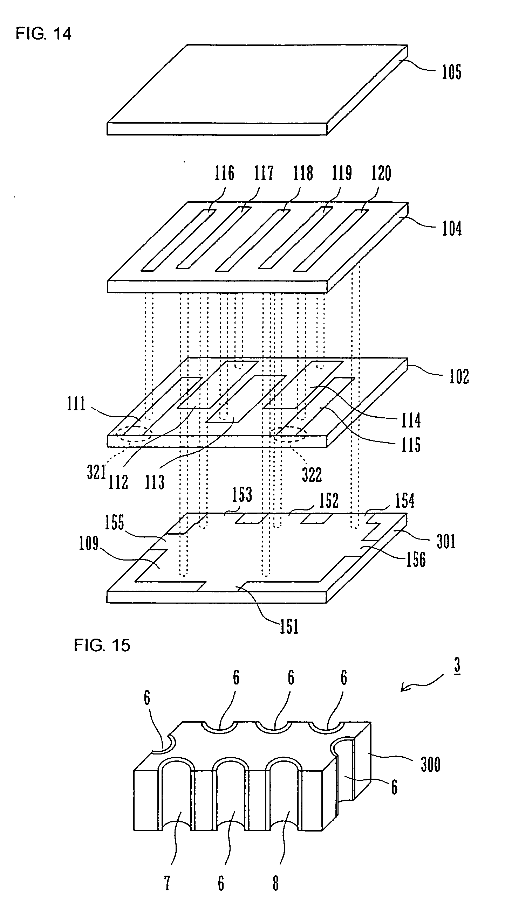

Fig. 14 is an exploded perspective view of a multilayer bandpass filter according to a sixth embodiment. Fig. 15 is an external perspective view of the multilayer bandpass filter.

In this embodiment, six ground connection electrodes 151 to 156 are led out from the ground electrode 109. In addition, capacitor electrodes 111 to 115 are formed on a capacitor electrode forming layer 102. Furthermore, input and output terminals 321 and 322 are continuously formed from the capacitor electrodes 111 and 115, respectively. The other structures are similar to those of the fifth embodiment. In this way, the input and output terminals 321 and 322 can be formed at desired positions.

### Seventh Embodiment

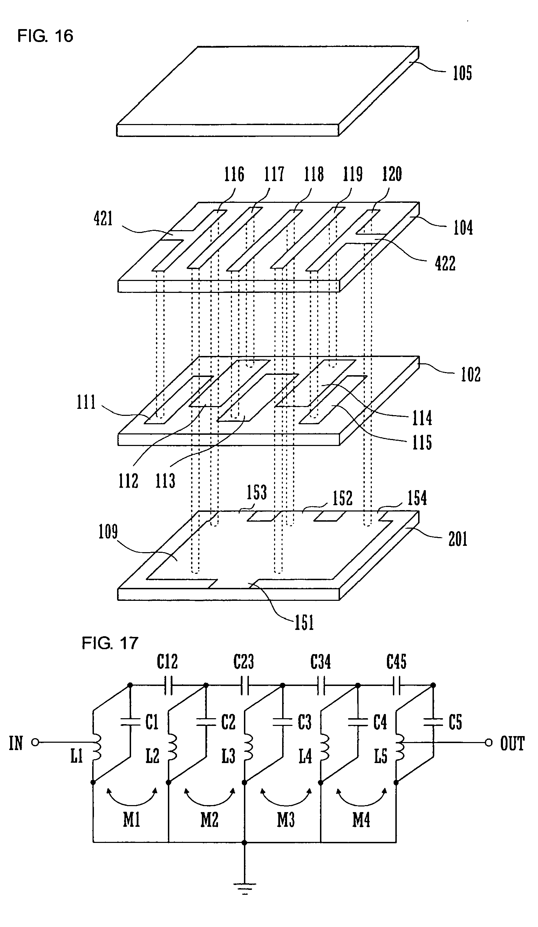

Fig. 16 is an exploded perspective view of a multilayer bandpass filter according to a seventh embodiment. Fig. 17 is an equivalent circuit diagram of the multilayer bandpass filter.

In this embodiment, line electrodes 116 to 120 are formed on a line electrode forming layer 104. In addition, input and output electrodes 421 and 422 are formed on the line electrode forming layer 104 so as to be conductively coupled with the line electrodes 116 and 120, respectively. Since the input and output electrodes 421 and 422 are formed on the line electrode forming layer 104, the need for a dielectric layer dedicated for input and output electrodes can be eliminated. In this multilayer bandpass filter, since the input and output electrodes 421 and 422 are led out from the middle portions (the intermediate portions) of the line electrodes 116 and 120, respectively, the equivalent circuit diagram shown in Fig. 17 can be obtained.

Accordingly, by determining the positions of the line electrodes 116 and 120 from which the input and output electrodes 421 and 422 are led out, the input and output impedance of the input-side and output-side LC parallel resonators can be determined.

### Eighth Embodiment

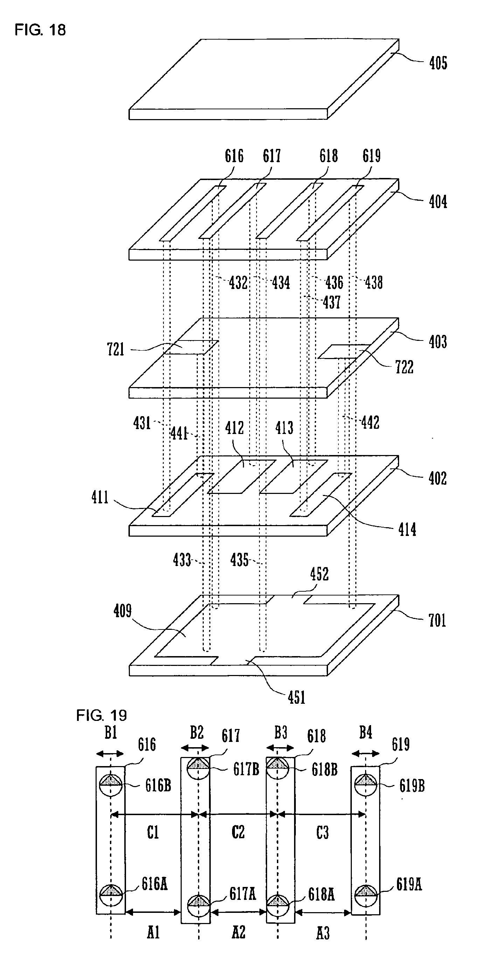

Fig. 18 is an exploded perspective view of a multilayer bandpass filter according to an eighth embodiment. The entire basic structure is similar to that shown in Fig. 2(A) if the third inductor electrode and the capacitor electrode 113 are removed from Fig. 2(A). However, the shapes, sizes, and locations of line electrodes 216 to 220 formed on the line electrode forming layer 104 are different. By determining the shapes, sizes, and locations of line electrodes 216 to 220, the inductance of the LC parallel resonators and the degree of coupling between the LC parallel resonators can be determined.

The multilayer bandpass filter has a laminated body including a ground electrode forming layer 701, a capacitor electrode forming layer 402, an input and output electrode forming layer 403, a line electrode forming layer 404, and an outer layer 405. Predetermined input and output terminal and ground terminal are provided on the end surfaces of the laminated body.

As shown in Fig. 18, input and output electrodes 721 and 722 are formed on the input and output electrode forming layer 403.

Capacitor electrodes 411, 412, 413, and 414 formed on the capacitor electrode forming layer 402 face a ground electrode 409.

A via electrode 441 is conductively coupled with the input and output electrode 721 and the capacitor electrode 411. A via electrode 442 is conductively coupled with the input and output electrode 722 and the capacitor electrode 414.

A via electrode 431 is conductively coupled with the capacitor electrode 411 and one end of a line electrode 616. A via electrode 432 is conductively coupled with the other end of the line electrode 616 and the ground electrode 409. A via electrode 433 is conductively coupled with the ground electrode 409 and one end of a line electrode 617. A via electrode 434 is conductively coupled with the other end of the line electrode 617 and the capacitor electrode 412. A via electrode 435 is conductively coupled with the ground electrode 409 and one end of a line electrode 618. A via electrode 436 is conductively coupled with the other end of the line electrode 618 and the capacitor electrode 413. A via electrode 437 is conductively coupled with the capacitor electrode 414 and one end of a line electrode 619. A via electrode 438 is conductively coupled with the other end of the line electrode 619 and the ground electrode 409.

Accordingly, the polarity sequence of coupling between the four (four-stage) LC parallel resonators is expressed as <1001>.

Fig. 19 illustrates a positional relationship among the line capacitors and the via capacitors connected thereto when the four-stage LC parallel resonators are formed.

In Fig. 19, A1 to A3 denote the distances between pairs of neighboring ones of the line electrodes 616 to 619, respectively. B1 to B4 denote the electrode widths of the line electrodes 616 to 619, respectively. Dimensions C1 to C3 denote the distances between the via electrodes in a direction in which the inductor electrodes are arranged.

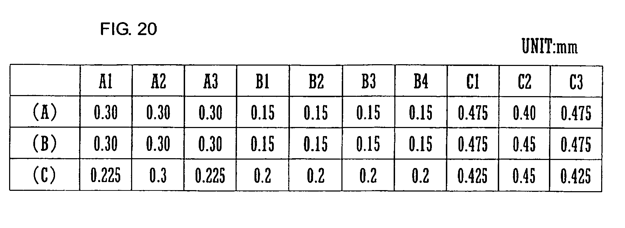

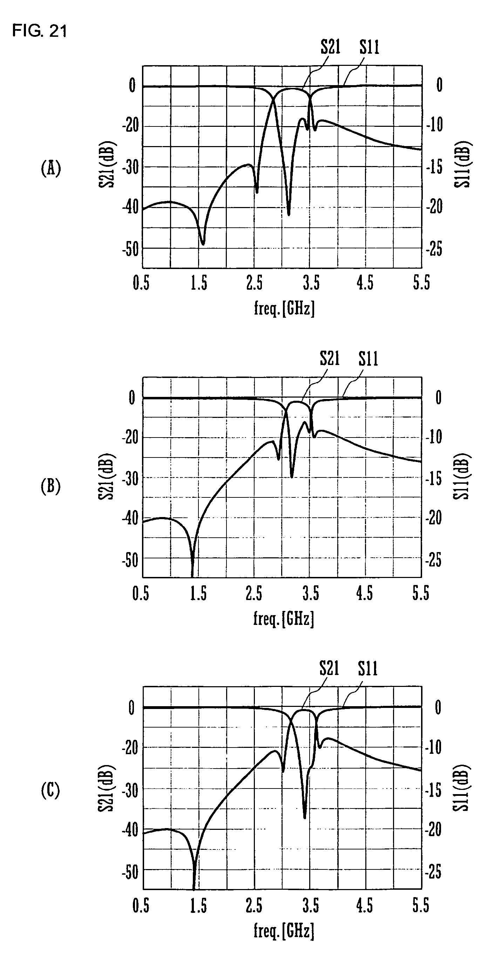

Fig. 20 illustrates three examples in which the above-described dimensions are changed. Fig. 21 is a diagram illustrating the bandpass characteristics (the S21 characteristics of the S-parameter) and the reflection characteristics (the S11 characteristics of the S-parameter) of the three bandpass filters. Note that, in order to eliminate the directivity of the input and output of the filters, A1 = A3, and C1 = C3. In addition, B1 = B4, and B2 = B3.

The capacitor electrodes 411 and 414 are connected to the line electrodes 616 and 619 using the via electrodes 431 and 437, respectively. The electrode sizes of the capacitor electrodes 411 and 414 are the same. The capacitor electrodes 412 and 413 are connected to the line electrodes 617 and 618 using the via electrodes 434 and 436, respectively. The electrode sizes of the capacitor electrodes 412 and 413 are the same. Note that the electrode size of the capacitor electrodes 411 and 414 may be the same as or different from the electrode size of the capacitor electrodes 412 and 413.

Figs. 20(A) and 21(A) illustrate a reference characteristic (a characteristic to be compared). In this embodiment, the bandpass characteristic having a passband of 2.8 to 3.5 GHz is obtained. Figs. 20(B) and 21(B) illustrate the reference characteristic when the dimension C2 is increased from that in Figs. 20(A) and 21(A). In this case, the bandpass characteristic having the passband of 3.2 to 3.5 GHz is obtained. As can be seen, the passband in Figs. 20(B) and 21(B) is decreased, as compared with that obtained in Figs. 20(A) and 21(A). In addition, under the conditions shown in Figs. 20(C) and 21(C), a lower-ripple characteristic can be obtained in substantially the same passband as that in Figs. 20(B) and 21(B).

### Ninth Embodiment

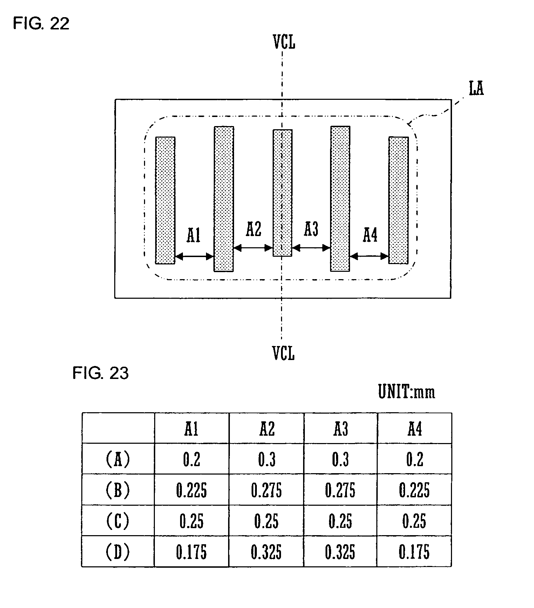

Fig. 22 is a plan view of a line electrode forming layer of a bandpass filter including a five-stage LC parallel resonators, and illustrates spaces A1 to A4 between pairs of neighboring line electrodes. In Fig. 22, an area LA represents an area over which line electrodes are distributed. A line VCL represents an imaginary center line that passes through the center point of the area LA and that extends parallel to each of the line electrodes. In the ninth embodiment, a change in the filter characteristic is described when the distances A1 to A4 between pairs of the neighboring line electrodes are changed.

Fig. 23 illustrates an example in which the distances A1 to A4 are changed in four patterns.

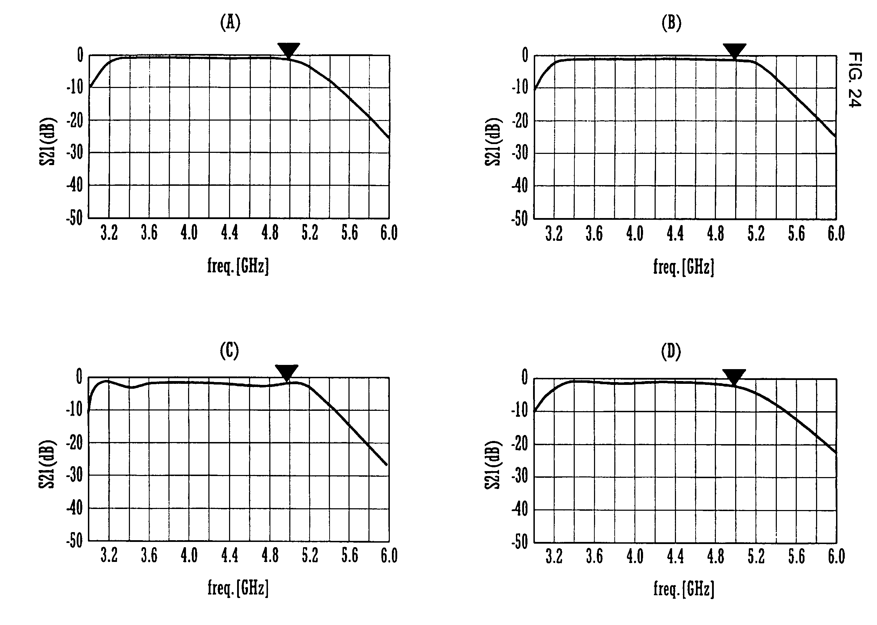

Figs. 24(A) to 24(D) represent the bandpass characteristics under the four conditions shown in Fig. 23. In Figs. 24(A) to 24(D), the lengths and widths of the five line electrodes and the distances A1 to A4 are determined so that the line electrodes are line-symmetrical with respect to the imaginary center line VCL.

Fig. 24(A) illustrates a reference characteristic (a characteristic to be compared). In Fig. 24(A), the bandpass characteristic having a passband of 3.2 to 5.0 GHz is obtained. When each of the distances A1 and A4 is increased and each of the distances A2 and A3 is decreased, the passband is expanded to the high-frequency side, as shown in Fig. 24(B).

Furthermore, when each of the distances A1 to A4 is increased, ripples in the passband increase, as shown in Fig. 24(C). Still furthermore, when each of the distances A1 and A4 is decreased and each of the distances A2 and A3 is increased, the passband ranges from 3.3 to 5.0 GHz, as shown in Fig. 24(D). As can be seen, the width of the passband in a low-frequency side is decreased.

### Tenth Embodiment

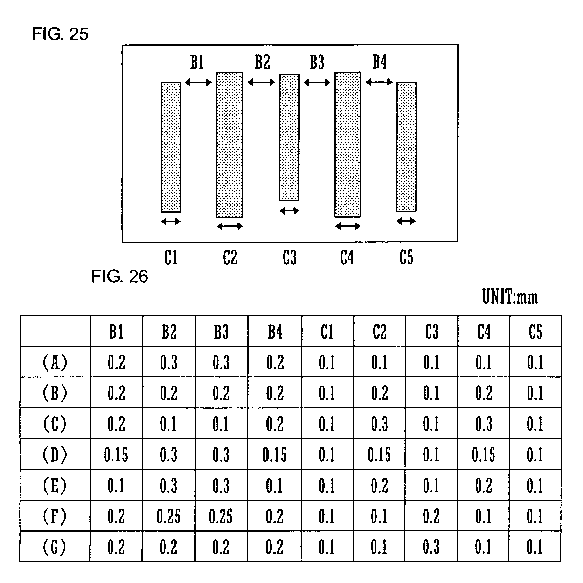

Fig. 25 is a plan view of a line electrode forming layer of a bandpass filter including a five-stage LC parallel resonators, and illustrates dimensions B1 to B4 between pairs of neighboring line electrodes and the widths C1 to C5 of the line electrodes. In the tenth embodiment, a change in the filter characteristic is described when the distances B1 to B4 between pairs of the neighboring line electrodes and the widths C1 to C5 of the line electrodes are changed.

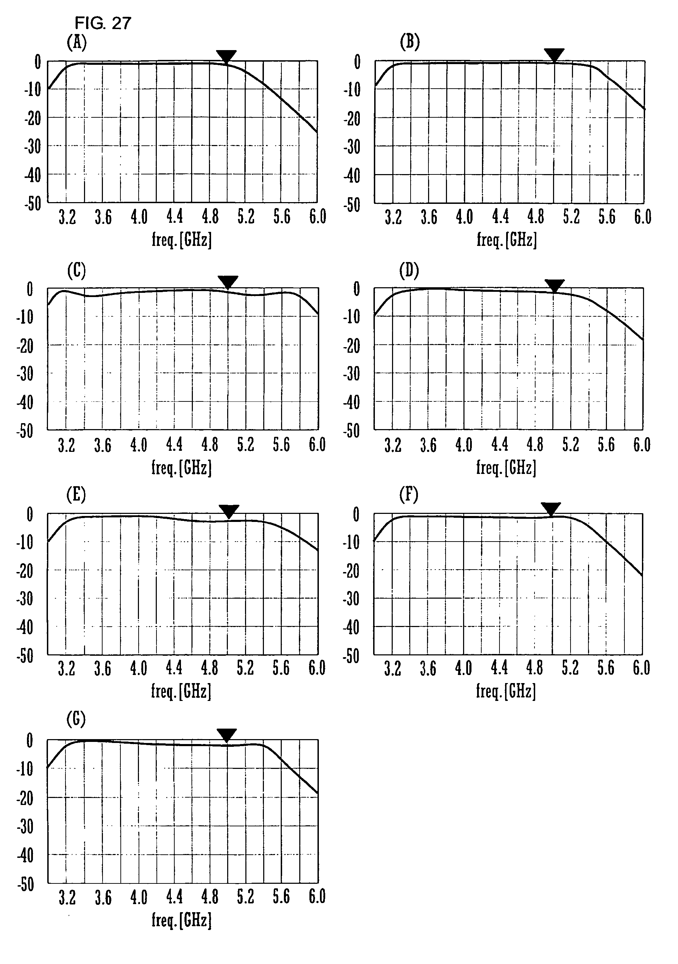

Fig. 26 illustrates an example in which the distances B1 to B4 and the widths C1 to C5 are changed in seven patterns. Figs. 27(A) to 27(G) represent the bandpass characteristics under the seven conditions shown in Fig. 26. Fig. 27(A) illustrates a reference characteristic (a characteristic to be compared). In Fig. 27(A), the bandpass characteristic having a passband of 3.2 to 5.0 GHz is obtained.

When each of the distances B2 and B3 is decreased and each of the widths C2 and C4 is increased from those of the condition (A), the passband is expanded to the high-frequency side, as shown in Fig. 27(B).

In addition, when each of the distances B2 and B3 is further decreased and each of the widths C2 and C4 is further increased, the passband is expanded to the high-frequency side, as shown in Fig. 27(C), and a ripple in the passband increases.

Furthermore, when each of the distances B1 and B4 is decreased and each of the widths C2 and C4 is increased from those of the condition (A), the passband is expanded to the high-frequency side, as shown in Fig. 27(D).

Still furthermore, when each of the distances B1 and B4 is further decreased and each of the widths C2 and C4 is further increased from those of the condition (D), the passband is further expanded to the high-frequency side, as shown in Fig. 27(E). However, ripples in the passband increase.

As can be seen from the comparison of Figs. 27(F) and 27(G), when each of the distances B2 and B3 is decreased and the width C3 is increased, the passband can be expanded.

### Eleventh Embodiment

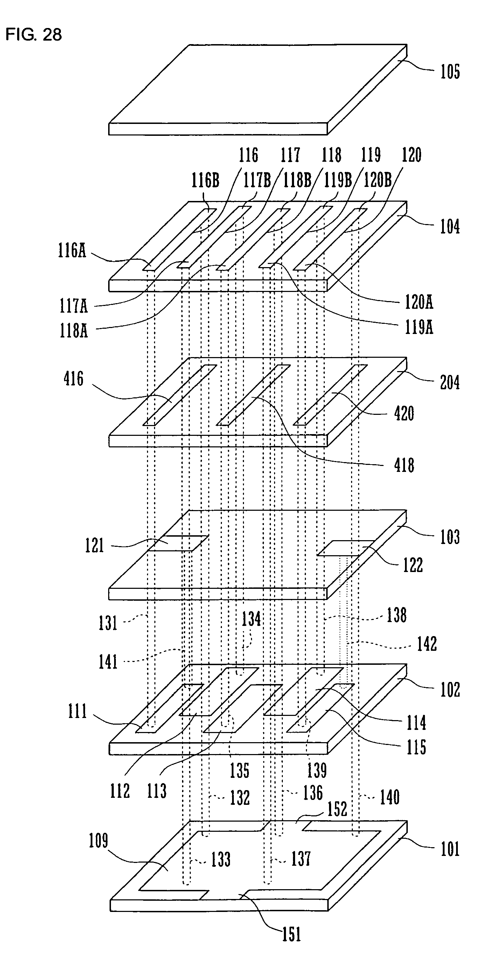

Fig. 28 is an exploded perspective view of a multilayer bandpass filter according to an eleventh embodiment. In this embodiment, two line electrode forming layers 104 and 204 are provided. Line electrodes 116 to 120 are formed on the line electrode forming layer 104. Line electrodes 416, 418, 420 are formed on the line electrode forming layer 204. A via electrode 131 is conductively coupled with one end of the line electrode 116 and one end of the line electrode 416. A via electrode 132 is conductively coupled with the other end of the line electrode 116 and the other end of the line electrode 416. A via electrode 135 is conductively coupled with one end of the line electrode 118 and one end of the line electrode 418. A via electrode 136 is conductively coupled with the other end of the line electrode 118 and the other end of the line electrode 418. Similarly, a via electrode 139 is conductively coupled with one end of the line electrode 120 and one end of the line electrode 420. A via electrode 140 is conductively coupled with the other end of the line electrode 120 and the other end of the line electrode 420.

Accordingly, the line electrodes 416, 418, and 420 are connected to the line electrodes 116, 118, and 120 in parallel using the via electrodes, respectively. In this way, the line electrodes of the inductor electrode can be multi-layered. Thus, a desired inductance value can be obtained. Furthermore, by decreasing the conductor loss of the line electrode and increasing the Q value of the inductor, the insertion loss can be reduced.

### Twelfth Embodiment

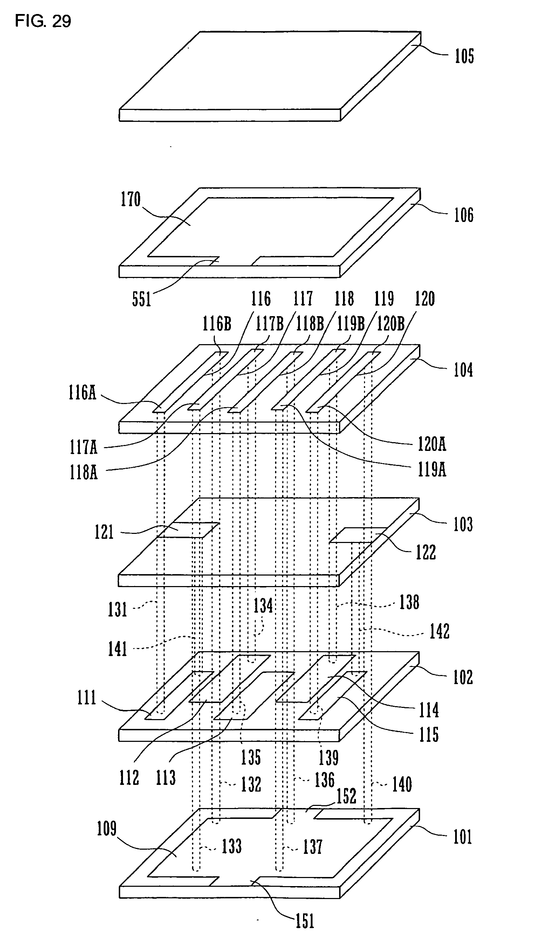

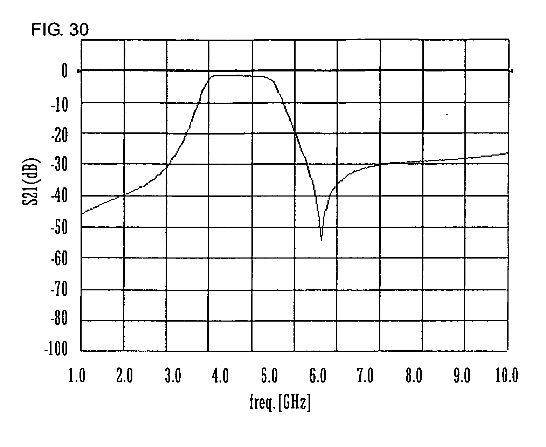

Fig. 29 is an exploded perspective view of one of two example structures of a multilayer bandpass filter according to a twelfth embodiment. Fig. 30 is a diagram illustrating the bandpass characteristic of the multilayer bandpass filter.

The multilayer bandpass filter has a laminated body including a ground electrode forming layer 101, a capacitor electrode forming layer 102, an input and output electrode forming layer 103, a line electrode forming layer 104, a traverse electrode forming layer 106, and an outer layer 105. Predetermined input and output terminals and ground terminal are provided on the end surfaces of the laminated body.

Unlike the multilayer bandpass filter shown in Fig. 2(A), in this embodiment, the traverse electrode forming layer 106 is provided. A traverse electrode 170 and a ground connection electrode 551 are formed on the traverse electrode forming layer 106. The ground connection electrode 551 and a ground connection electrode 151 formed on the ground electrode forming layer 101 are conductively coupled with the ground terminal formed on the side surface of the laminated body.

In this way, the traverse electrode 170 insulatingly extends across the inductor electrode (in particular, line electrodes 116 to 120 in this embodiment), and is connected to ground.

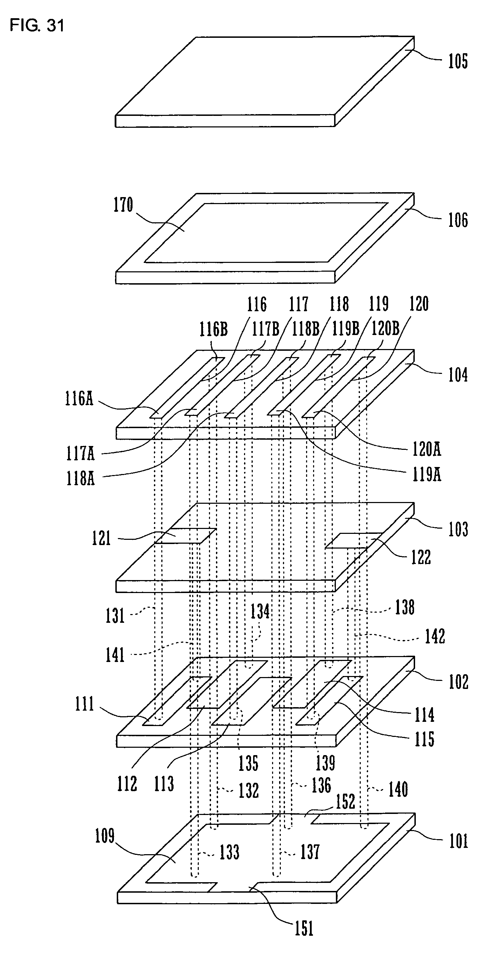

Fig. 31 is an exploded perspective view of the other multilayer bandpass filter including a traverse electrode forming layer having a different structure. In this example, a traverse electrode 170 that is not connected to ground is formed on the traverse electrode forming layer 106. As described above, since the filter characteristic varies depending on whether the traverse electrode 170 is connected to ground or not, the traverse electrode 170 is appropriately selected for the intended use. Even in such a case, the characteristic can be changed without changing the electrode patterns on the other layers.

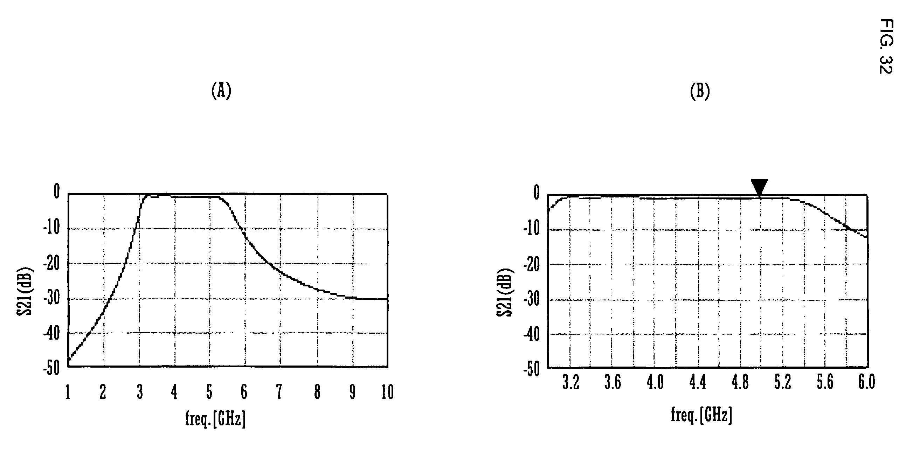

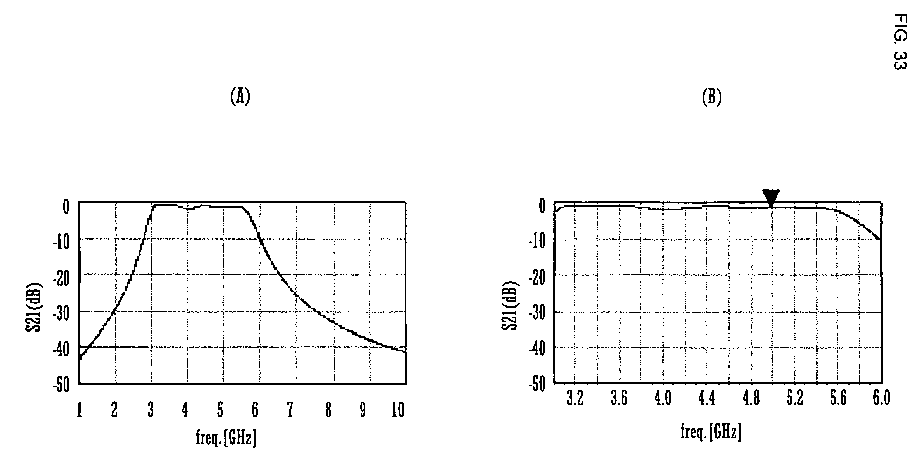

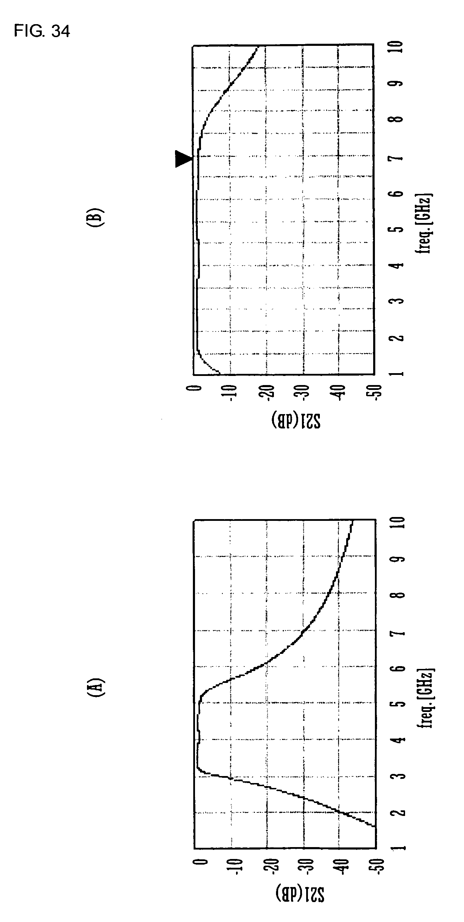

Figs. 32 to 34 illustrate a change in the filter characteristic in accordance with whether the traverse electrode is present or not and whether the traverse electrode is connected to ground or not. In this example, three-stage LC parallel resonators are employed. Fig. 32 illustrates an example in which the traverse electrode is not provided. Fig. 33 illustrates an example in which an ungrounded traverse electrode is provided. Fig. 34 illustrates an example in which a grounded traverse electrode is provided. As can be seen from a comparison of Fig. 32 and Fig. 33, when an ungrounded traverse electrode is provided, the passband can be increased, and the attenuation can be made steep from the passband to the higher-frequency stopband. In addition, when a grounded traverse electrode is provided, the passband can be decreased, and the attenuation can be made steep from the passband to the attenuation band.

Although not shown, by changing the shape and the size of the traverse electrode and the thickness of the dielectric material of the traverse electrode forming layer, the passband characteristic of the filter can be changed.

### Thirteenth Embodiment

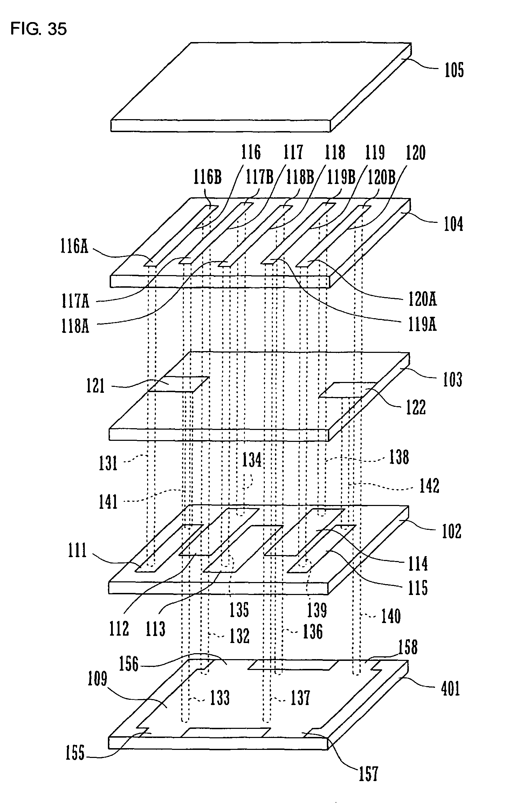

Fig. 35 is an exploded perspective view of a multilayer bandpass filter according to a thirteenth embodiment.

Unlike the multilayer bandpass filter shown in Fig. 2(A), in the thirteenth embodiment, an inductance component formed between a ground electrode 109 and a ground terminal formed on the side surface of the laminated body is actively determined by appropriately determining the number of ground connection electrodes 155 to 158 formed on a ground electrode forming layer 401 and the widths and the location of the ground connection electrodes 155 to 158.

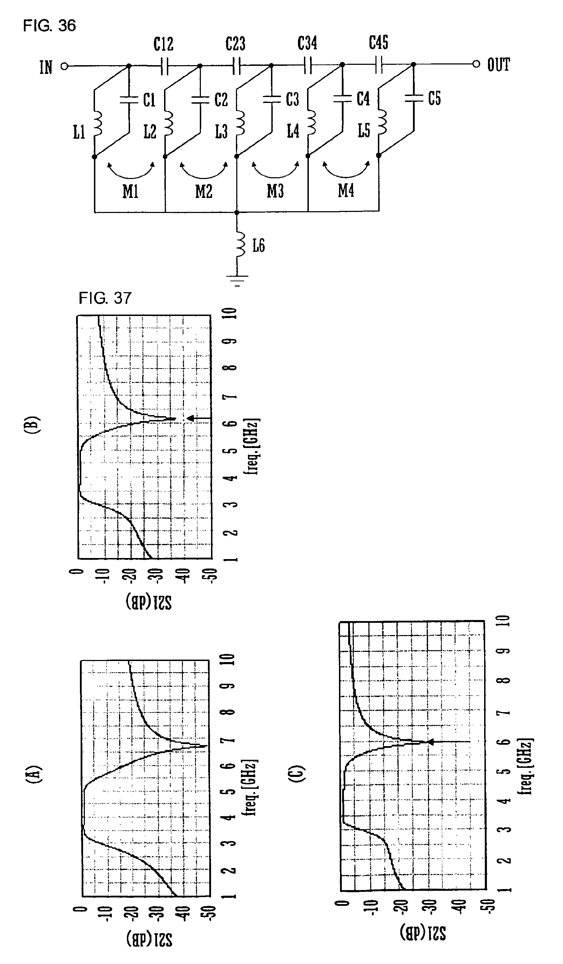

Fig. 36 is an equivalent circuit diagram of the multilayer bandpass filter. An inductor L6 represents an inductance component produced by the ground connection electrodes 155 to 158. The inductor L6 can be determined by changing the number, the widths, and the lengths of the ground connection electrodes 155 to 158.

Note that, in the equivalent circuit diagrams shown in Figs. 3, 5, 13, and 17 and Figs. 41, 43, 46, 47, 49, and 53, which are described below, the reference symbol of an inductor indicating the inductance component produced by the ground connection electrodes is not shown.

Fig. 37 illustrates the bandpass characteristics when the inductor L6 has three values. Fig. 37(A) illustrates the bandpass characteristic when L6 = 0.03 nH. Fig. 37(B) illustrates the bandpass characteristic when L6 = 0.10 nH. Fig. 37(C) illustrates the bandpass characteristic when L6 = 0.20 nH.

As can be seen from the drawings, as the inductance of the inductor L6 decreases, the attenuation at the attenuation pole occurring on the high-frequency side of the passband increases. In addition, when the inductance of the inductor L6 is increased, the attenuation characteristic is made steep from the passband to the high-frequency side.

### Fourteenth Embodiment

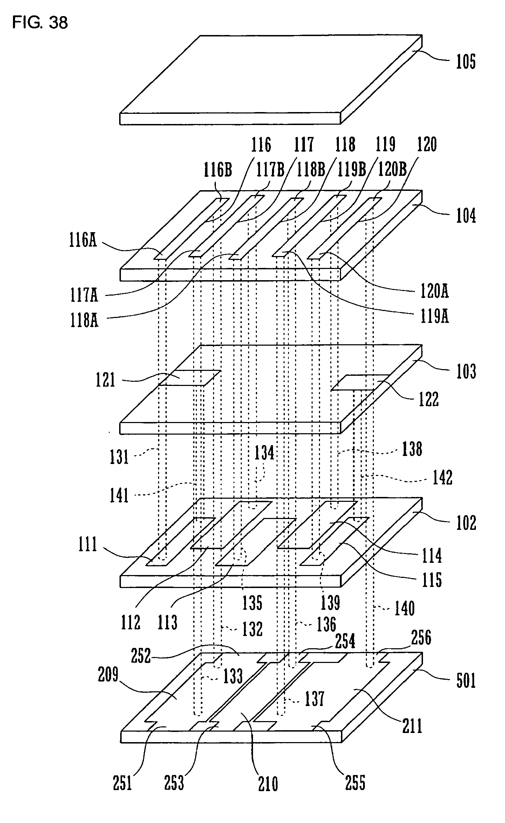

Fig. 38 is an exploded perspective view of a multilayer bandpass filter according to a fourteenth embodiment.

In this embodiment, three separate ground electrodes 209 to 211 and ground connection electrodes 251 to 256 led out from the ground electrodes 209 to 211 are formed on a ground electrode forming layer 501.

Capacitor electrodes 111 and 112 formed on a capacitor electrode forming layer 102 face the ground electrode 209. A capacitor electrode 113 faces the ground electrode 210. Capacitor electrodes 114 and 115 face the ground electrode 211. In addition, via electrodes 132 and 133 are conductively coupled with the ground electrode 209. A via electrode 136 is conductively coupled with the ground electrode 210. Via electrodes 137 and 140 are conductively coupled with the ground electrode 211.

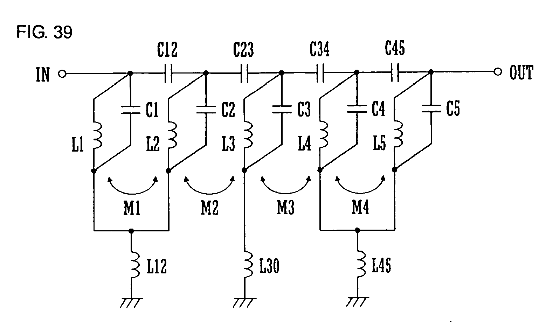

Accordingly, the equivalent circuit diagram of the multilayer bandpass filter is shown in Fig. 39. In Fig. 39, an inductor L12 represents an inductance component produced by the ground connection electrodes 251 and 252. An inductor L30 represents an inductance component produced by the ground connection electrodes 253 and 254. An inductor L45 represents an inductance component produced by the ground connection electrodes 255 and 256.

As described above, when predetermined capacitor electrodes face each other, and a plurality of ground electrodes that are conductively coupled with predetermined via electrodes are separated, a multilayer bandpass filter having a characteristic different from that of a multilayer bandpass filter having a common ground electrode can be achieved.

### Fifteenth Embodiment

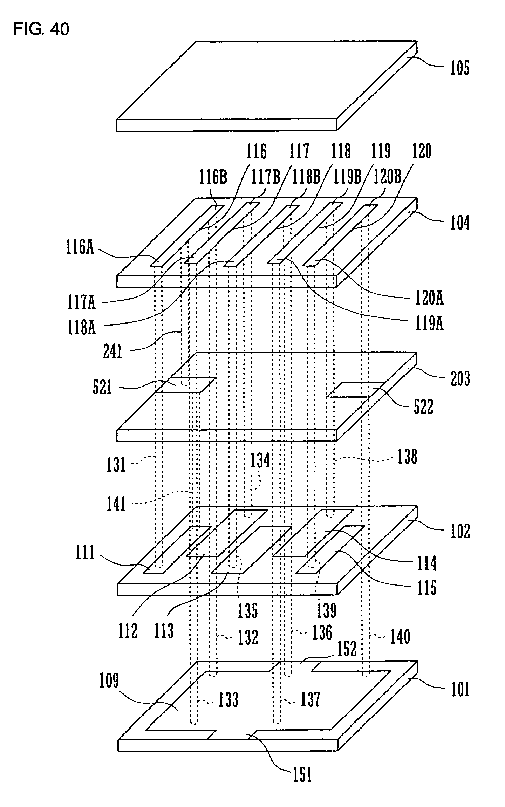

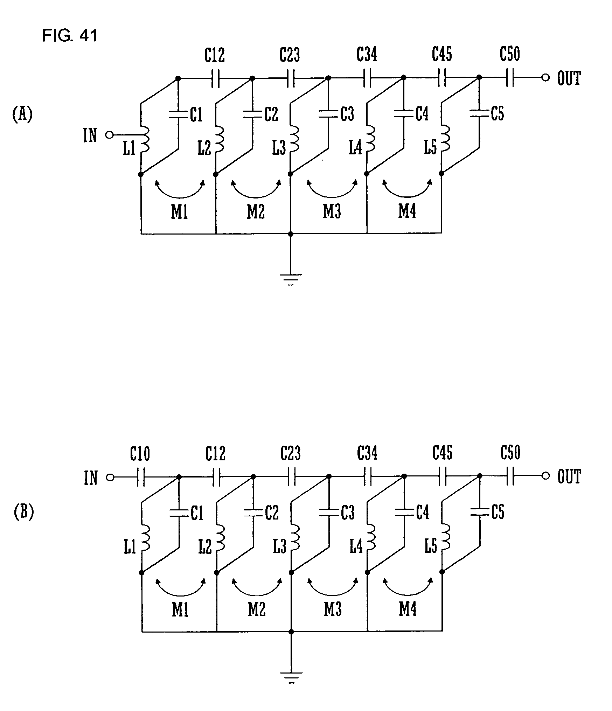

Fig. 40 is an exploded perspective view of a multilayer bandpass filter according to a fifteenth embodiment. Fig. 41(A) is an equivalent circuit diagram of the filter. In the example shown in Fig. 2(A), the input and output electrode 121 formed on the input and output electrode forming layer 103 are conductively coupled with the capacitor electrode 111 formed on the capacitor electrode forming layer 102 using the via electrode 141. However, in an example shown in Fig. 40, a via electrode 241 that is conductively coupled with the middle portion of a line electrode 116 and an input and output electrode 521 is provided.

In addition, in the example shown in Fig. 2(A), the via electrode 142 that is conductively coupled with the capacitor electrode 115 and the input and output electrode 122 is provided. However, in an example shown in Fig. 40, an input and output electrode 522 is formed so that a capacitance is produced between the input and output electrode 522 and a capacitor electrode 115.

Accordingly, the equivalent circuit diagram of the multilayer bandpass filter shown in Fig. 40 is shown in Fig. 41(A). In the equivalent circuit diagram, an inductor L1 is formed by the via electrodes 131 and 132 and the line electrode 116. A capacitor C50 is a capacitor having a capacitance formed between the capacitor electrode 115 and the input and output electrode 522. In this way, the multilayer bandpass filter can be used as a filter that receives an input using inductance division (inductive coupling) and delivers the output using capacitance retrieval (capacitive coupling). In the circuit design, if the input and output impedance of the multilayer bandpass filter is high, inductance division can be performed. In contrast, if the input and output impedance of the multilayer bandpass filter is low, input and output impedance matching can be achieved using capacitance retrieval.

If the via electrode 241 shown in Fig. 40 is not provided, external coupling can be established by using the capacitance formed between the input and output electrode 521 and the capacitor electrode 111. In such a case, the equivalent circuit is shown in Fig. 41(B). In Fig. 41(B), a capacitor C10 is a capacitor having the capacitance formed between the input and output electrode 521 and the capacitor electrode 111.

As described above, capacitive coupling may be employed for both input and output. The input and output method can be easily changed simply by providing or removing the via electrode.

### Sixteenth Embodiment

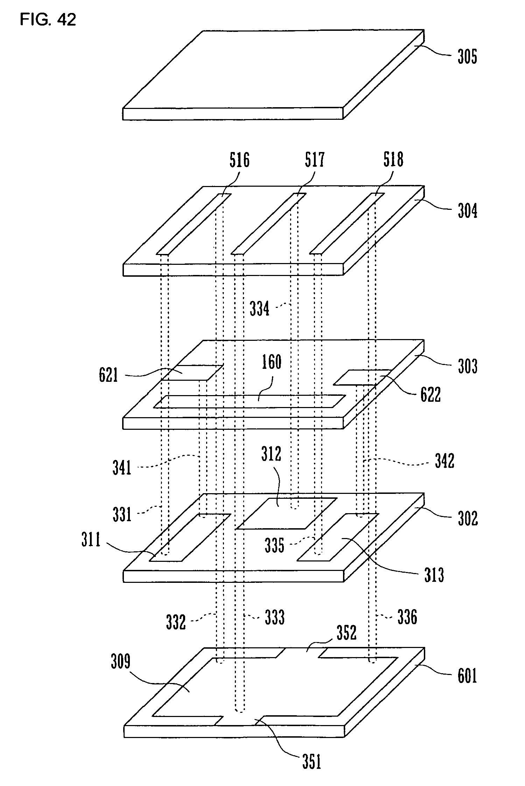

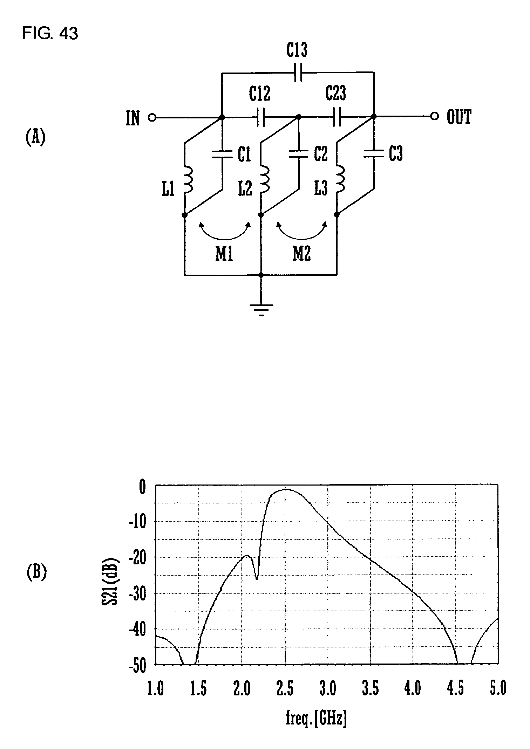

Fig. 42 is an exploded perspective view of a multilayer bandpass filter according to a sixteenth embodiment. Fig. 43(A) is an equivalent circuit diagram of the multilayer bandpass filter. Fig. 43(B) illustrates the bandpass characteristic of the multilayer bandpass filter.

The multilayer bandpass filter has a laminated body including a ground electrode forming layer 601, a capacitor electrode forming layer 302, an input and output electrode forming layer 303, a line electrode forming layer 304, and an outer layer 305. Predetermined input and output terminals and ground terminal are provided on the end surfaces of the laminated body.

As shown in Fig. 42, input and output electrodes 621 and 622 and an input-output intermediate capacitor electrode 160 are formed on an input and output electrode forming layer 303. The input-output intermediate capacitor electrode 160 produces a capacitance between itself and the input and output electrode 621 and a capacitance between itself and the input and output electrode 622 so as to achieve capacitive coupling between the input and output electrodes 621 and 622.

Capacitor electrodes 311, 312, and 313 of the capacitor electrode forming layer 302 face a ground electrode 309.

A via electrode 341 is conductively coupled with the input and output electrode 621 and the capacitor electrode 311. A via electrode 342 is conductively coupled with the input and output electrode 622 and the capacitor electrode 313.

A via electrode 331 is conductively coupled with the capacitor electrode 311 and one end of a line electrode 516. A via electrode 332 is conductively coupled with the other end of the line electrode 516 and the ground electrode 309. A via electrode 333 is conductively coupled with the ground electrode 309 and one end of a line electrode 517. A via electrode 334 is conductively coupled with the other end of the line electrode 517 and the capacitor electrode 312. A via electrode 335 is conductively coupled with the capacitor electrode 313 and one end of a line electrode 518. A via electrode 336 is conductively coupled with the other end of the line electrode 518 and the ground electrode 309.

Accordingly, the polarity sequence of coupling between the three (three-stage) LC parallel resonators is expressed as <101>.

The equivalent circuit diagram of the multilayer bandpass filter is shown in Fig. 43(A). In Fig. 43(A), a capacitor C13 is a capacitor having the capacitance formed between the input and output electrodes 621 and 622 when the input-output intermediate capacitor electrode 160 is provided.

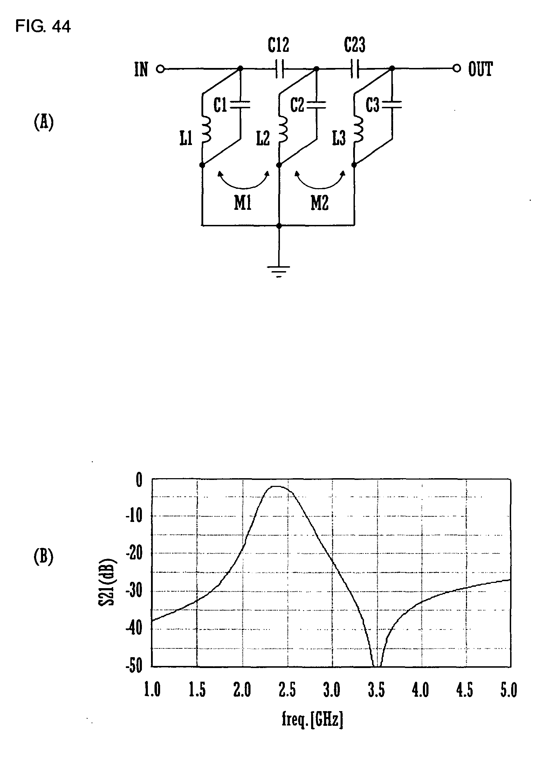

As described above, by coupling three resonators so as to have a polarity sequence of <101> and by capacitively coupling the first-stage resonator with the third-stage resonator, the bandpass characteristic shown in Fig. 43(B) is obtained. For the purpose of comparison, Fig. 44(A) illustrates an equivalent circuit of a configuration having no input-output intermediate capacitor electrode, and Fig. 44(B) illustrates a filter characteristic of the configuration.

As can be seen from comparison of Fig. 43(B) and Fig. 44(B), the presence of the input-output intermediate capacitor electrode causes an attenuation pole on the high-frequency side of the passband to shift to the high-frequency side. However, two attenuation poles appear on the low-frequency side of the passband, which results in an increase in steepness of attenuation from the passband to the lower-frequency side.

As described above, jumping coupling between resonators is easily achieved simply by forming the input-output intermediate capacitor electrode on the input and output electrode forming layer. Accordingly, the presence/absence of the input-output intermediate capacitor electrode and the shape and the location thereof can be determined in accordance with the desired filter characteristics.

### Seventeenth Embodiment

According to a seventeenth embodiment, a multilayer bandpass filter has a four-stage LC parallel resonator configuration having an input-output intermediate capacitor electrode.

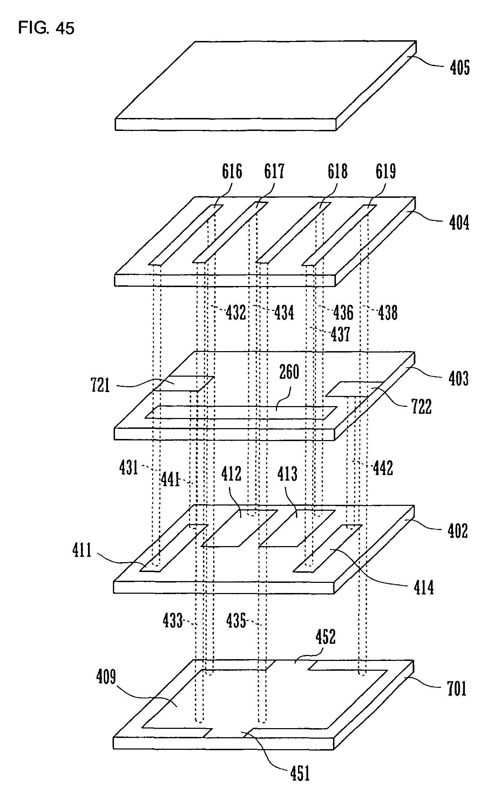

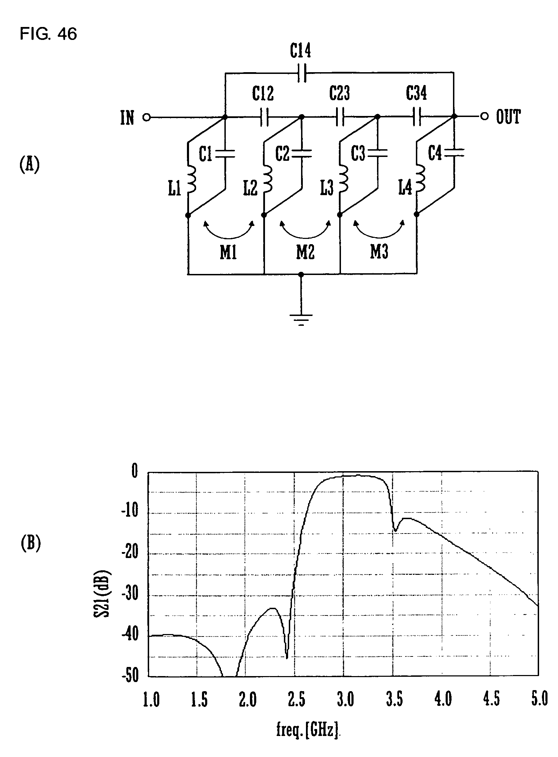

Fig. 45 is an exploded perspective view of the multilayer bandpass filter according to the seventeenth embodiment. Fig. 46(A) is an equivalent circuit diagram of the multilayer bandpass filter. Fig. 46(B) illustrates the bandpass characteristic of the multilayer bandpass filter.

The multilayer bandpass filter has a laminated body including a ground electrode forming layer 701, a capacitor electrode forming layer 402, an input and output electrode forming layer 403, a line electrode forming layer 404, and an outer layer 405. Predetermined input and output terminal and ground terminal are provided on the end surfaces of the laminated body.

As shown in Fig. 45, input and output electrodes 721 and 722 and an input-output intermediate capacitor electrode 260 are formed on the input and output electrode forming layer 403. The input-output intermediate capacitor electrode 260 produces a capacitance between itself and the input and output electrode 721 and a capacitance between itself and the input and output electrode 722 so as to achieve capacitive coupling between the input and output electrodes 721 and 722.

Capacitor electrodes 411, 412, 413, and 414 of the capacitor electrode forming layer 402 face a ground electrode 409.

A via electrode 441 is conductively coupled with the input and output electrode 721 and the capacitor electrode 411. A via electrode 442 is conductively coupled with the input and output electrode 722 and the capacitor electrode 414.

A via electrode 431 is conductively coupled with the capacitor electrode 411 and one end of a line electrode 616. A via electrode 432 is conductively coupled with the other end of the line electrode 616 and the ground electrode 409. A via electrode 433 is conductively coupled with the ground electrode 409 and one end of a line electrode 617. A via electrode 434 is conductively coupled with the other end of the line electrode 617 and the capacitor electrode 412. A via electrode 435 is conductively coupled with the ground electrode 409 and one end of a line electrode 618. A via electrode 436 is conductively coupled with the other end of the line electrode 618 and the capacitor electrode 413. A via electrode 437 is conductively coupled with the capacitor electrode 414 and one end of a line electrode 619. A via electrode 438 is conductively coupled with the other end of the line electrode 619 and the ground electrode 409.

Accordingly, the polarity sequence of coupling between the four (four-stage) LC parallel resonators is expressed as <1001>.

The equivalent circuit diagram of the multilayer bandpass filter is shown in Fig. 46(A). In Fig. 46(A), a capacitor C14 is a capacitor having the capacitance formed between the input and output electrodes 721 and 722 when the input-output intermediate capacitor electrode 260 is provided.

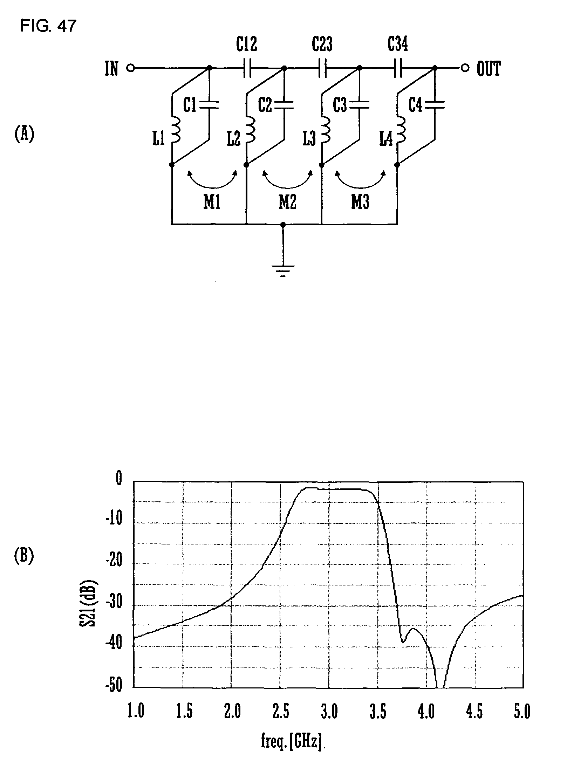

As described above, by sequentially coupling four resonators so as to have a polarity sequence of <1001> and by capacitively coupling the first-stage resonator with the fourth-stage resonator, the bandpass characteristic shown in Fig. 46(B) is obtained. For the purpose of comparison, Fig. 47(A) illustrates an equivalent circuit of a configuration having no input-output intermediate capacitor electrode, and Fig. 47(B) illustrates a filter characteristic of the configuration.

As can be seen from comparison of Fig. 46(B) and Fig. 47(B), the presence of the input-output intermediate capacitor electrode causes an attenuation pole to appear on the high-frequency side of the passband and causes two attenuation poles to appear on the low-frequency side of the passband. Thus, the attenuation characteristic from the passband to the lower-frequency side and the attenuation characteristic from the passband to the higher-frequency side can be made steep.

### Eighteenth Embodiment

According to an eighteenth embodiment, a multilayer bandpass filter has a four-stage LC parallel resonator configuration having an input-output intermediate capacitor electrode.

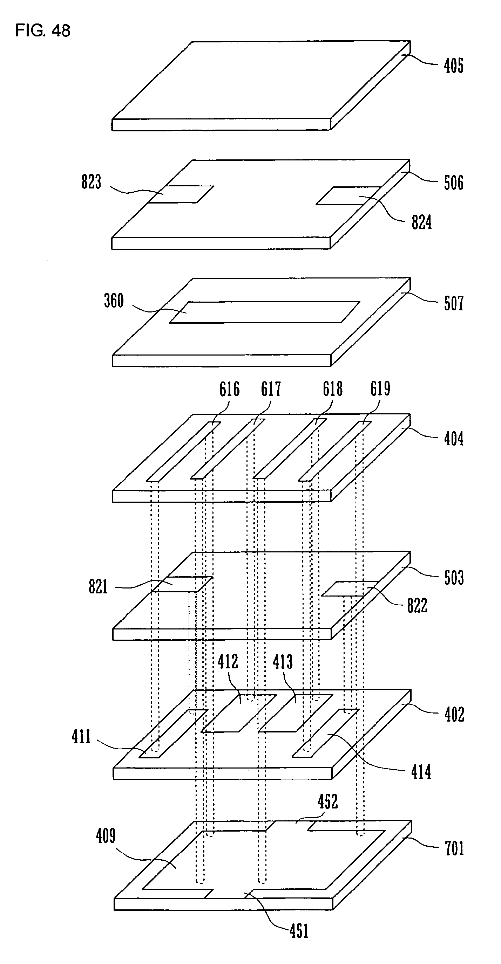

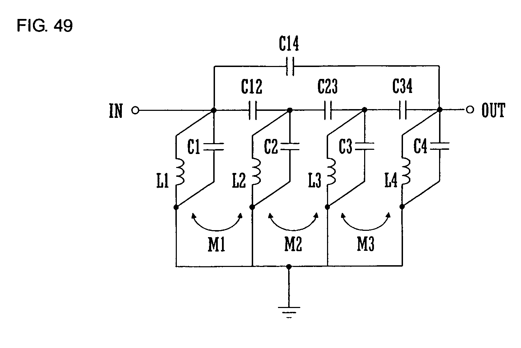

Fig. 48 is an exploded perspective view of the multilayer bandpass filter according to the eighteenth embodiment. Fig. 49 is an equivalent circuit diagram of the multilayer bandpass filter.

The multilayer bandpass filter has a laminated body including a ground electrode forming layer 701, a capacitor electrode forming layer 402, input and output electrode forming layers 503 and 506, a line electrode forming layer 404, an input-output intermediate capacitor electrode forming layer 507, and an outer layer 405. Predetermined input and output terminals and ground terminal are provided on the end surfaces of the laminated body.

In this embodiment, input and output electrodes 823 and 824 are formed on the input and output electrode forming layer 506. Input and output electrodes 821 and 822 are formed on the input and output electrode forming layer 503. In addition, an input-output intermediate capacitor electrode 360 is formed on the input-output intermediate capacitor electrode forming layer 507 other than the two input and output electrode forming layers 506 and 503. The input-output intermediate capacitor electrode 360 produces a capacitance between itself and the input and output electrode 823 and a capacitance between itself and the input and output electrode 824 so as to achieve capacitive coupling between the input side and output side. In addition, the input-output intermediate capacitor electrode 360 further functions as a traverse electrode extending across the line electrodes 616 to 619. In this example, the other structures are similar to those of the seventeenth embodiment.

The input and output electrodes 821 and 823 are connected to a terminal electrode formed on one end surface of the laminated body. In addition, the input and output electrodes 822 and 824 are connected to a terminal electrode formed on the other end surface of the laminated body.

In Fig. 49, a capacitor C14 is a capacitor having the total capacitance including capacitances between the input and output electrodes 823 and the input-output intermediate capacitor electrode 360 and between the input-output intermediate capacitor electrode 360 and the input and output electrode 824. Note that, when the input-output intermediate capacitor electrode 360 functions as a traverse electrode, the input-output intermediate capacitor electrode 360 can be considered as a distributed constant line, and therefore, the distributed constant line is not shown in Fig. 49.

### Nineteenth Embodiment

According to a nineteenth embodiment, a multilayer bandpass filter has a four-stage LC parallel resonator configuration having an input-output intermediate capacitor electrode and an internal ground electrode on each of the layers other than the bottom layer.

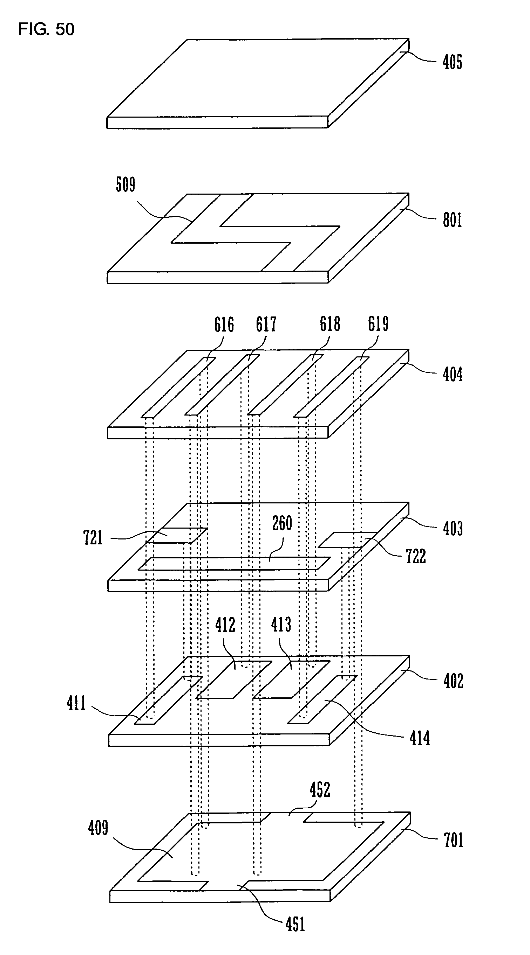

Fig. 50 is an exploded perspective view of the multilayer bandpass filter according to the nineteenth embodiment. In this multilayer bandpass filter, a ground electrode forming layer 701, a capacitor electrode forming layer 402, an input and output electrode forming layer 403, and a line electrode forming layer 404 have structures similar to those shown in Fig. 45. In the configuration shown in Fig. 50, a ground electrode forming layer 801 is further provided between the line electrode forming layer 404 and the outer layer 405. A crank-shaped ground electrode 509 is formed on the ground electrode forming layer 801. Of portions of the crank-shaped ground electrode 509, portions which are parallel to each other are disposed so as to partially face the corresponding line electrodes 617 and 618 in parallel. Thus, a distributed capacitance is formed between the inductor of a second-stage LC parallel resonator and the ground and between the inductor of the third-stage LC parallel resonator and the ground.

As described above, by disposing a ground electrode forming layer in a basic structure including a plurality of LC parallel resonators inductively coupled with each other, an additional circuit can be easily added to the basis structure, thereby changing the filter characteristic in various manners.

### Twentieth Embodiment

According to a twentieth embodiment, a multilayer bandpass filter has a five-stage LC parallel resonator configuration having a chip inductor.

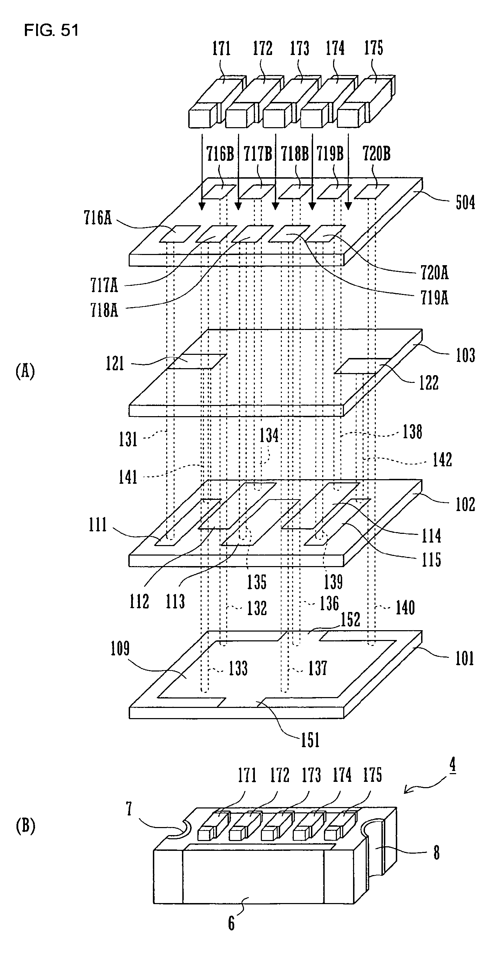

Fig. 51(A) is an exploded perspective view of the multilayer bandpass filter according to the twentieth embodiment. Fig. 51(B) is an external perspective view of the multilayer bandpass filter.

The multilayer bandpass filter has a laminated body including a ground electrode forming layer 101, a capacitor electrode forming layer 102, input and output electrode forming layer 103, and a line electrode forming layer 504. In addition, input and output terminals 7 and 8 and a ground terminal 6 are provided on the laminated body. Furthermore, chip inductors 171 and 175 are implemented (mounted) on the laminated body.

As shown in Fig. 51(A), chip-inductor connection electrodes (716A, 716B) to (720A, 720B) are provided on the line electrode forming layer 504.

Via-electrodes are disposed between the line electrode forming layer 504 and the capacitor electrode forming layer 102 and between the line electrode forming layer 504 and the ground electrode forming layer 101 in a similar manner to the configuration shown in Fig. 2(A). Thus, an equivalent circuit of this filter configuration having the chip inductors 171 to 175 mounted on the laminated body is similar to that shown in Fig. 3(A).

Thus, by changing the inductance values of the chip inductors 171 to 175, the filter characteristics can be easily changed without changing the laminated body.

In addition, use of the chip inductors allows the inductance values of the inductors of the LC parallel resonators to be high. Accordingly, a compact bandpass filter suitable for use in relatively low frequency bands can be achieved.

### Twenty-First Embodiment

In the embodiments described above, the inductor electrodes and the capacitor electrodes are arranged in a direction that is perpendicular to a direction in which the dielectric layers and the electrode layers are stacked. In a twenty-first embodiment, inductor electrodes and capacitor electrodes are arranged in the direction in which dielectric layers and electrode layers are stacked.

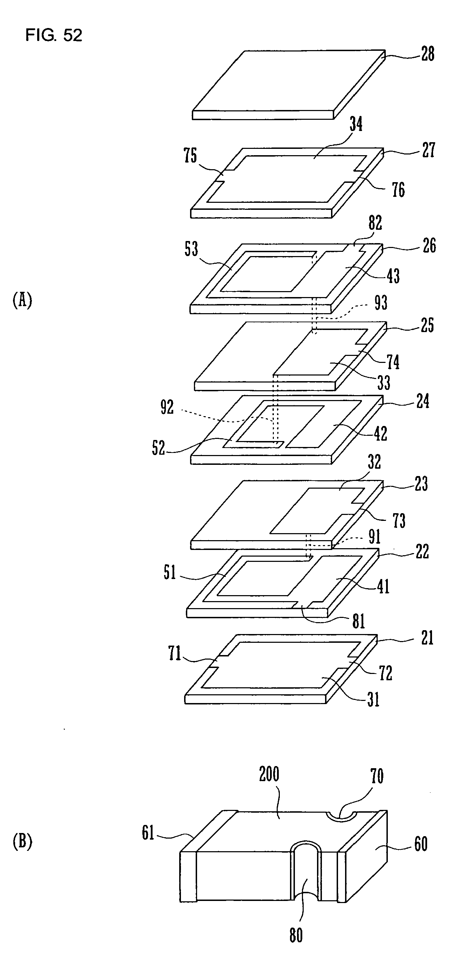

Fig. 52 is an exploded perspective view of a multilayer bandpass filter according to the twenty-first embodiment.

The multilayer bandpass filter has a laminated body 200 including ground electrode forming layers 21, 23, 25, and 27, inductor and capacitor electrode forming layers 22, 24, and 26, and an outer layer 28. In addition, input and output terminals 70 and 80 and ground terminals 60 and 61 are provided on side surfaces of the laminated body 200.

A ground electrode 31 and ground connection electrodes 71 and 72 are formed on the ground electrode forming layer 21. A ground electrode 32 and a ground connection electrode 73 are formed on the ground electrode forming layer 23. A ground electrode 33 and a ground connection electrode 74 are formed on the ground electrode forming layer 25. A ground electrode 34 and ground connection electrodes 75 and 76 are formed on the ground electrode forming layer 27.

Capacitor electrodes 41, 42, and 43 and inductor electrodes 51, 52, and 53 are formed on the inductor and capacitor electrode forming layers 22, 24, and 26, respectively. In addition, a via electrode 91 conductively coupled with one end of the inductor electrode 51 and the ground electrode 32, a via electrode 92 conductively coupled with one end of the inductor electrode 52 and the ground electrode 33, and a via electrode 93 conductively coupled with one end of the inductor electrode 53 and the ground electrode 33 are provided.

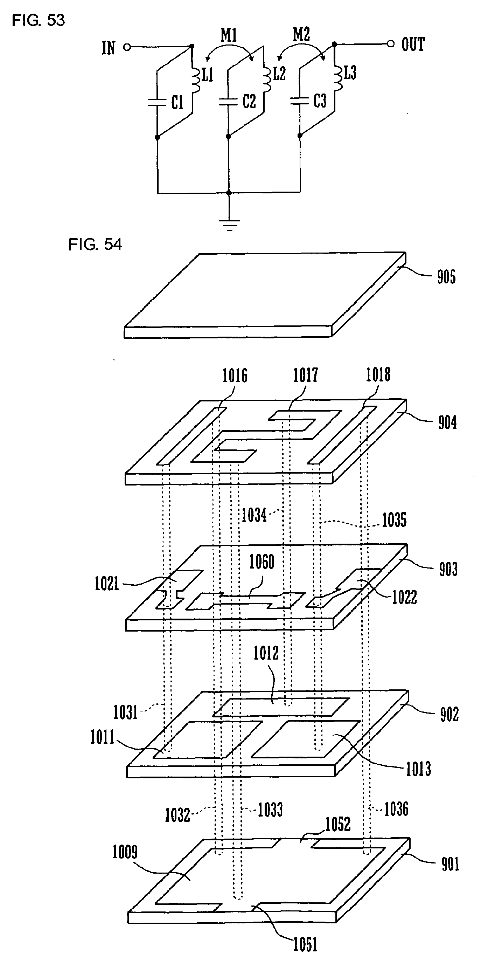

In this way, a circuit indicated by an equivalent circuit diagram shown in Fig. 53 can be achieved. In Fig. 53, the capacitors C1 to C3 are capacitors having capacitances formed between the respective capacitor electrodes 41 to 43 and the ground electrodes 31 to 34, respectively. Inductors L1 to L3 represent inductance components formed by the inductor electrodes 51 to 53, respectively. As shown in Fig. 52, the loop direction of the inductor electrode 52 is opposite to the loop directions of the inductor electrodes 51 and 53, and therefore, the polarities of inductive coupling M1 and inductive coupling M2 shown in Fig. 53 are opposite, that is, the polarity sequence of coupling is <101>. In addition, since the ground terminal 61 faces and extends across parts of the inductor electrodes 51 to 53, the ground terminal 61 also functions as a traverse electrode.

In the embodiments described above, the capacitor electrodes are formed on the capacitor electrode forming layer so as to achieve capacitors of the LC parallel resonators. However, chip capacitors may be mounted on a laminated body including dielectric layers and electrode layers.

Furthermore, in the embodiments described above, a capacitance is produced between the common ground electrode and each of the capacitor electrodes. However, in place of the ground electrode, another capacitor electrode may be formed on another electrode forming layer so as to produce a capacitance.

### Twenty-Second Embodiment

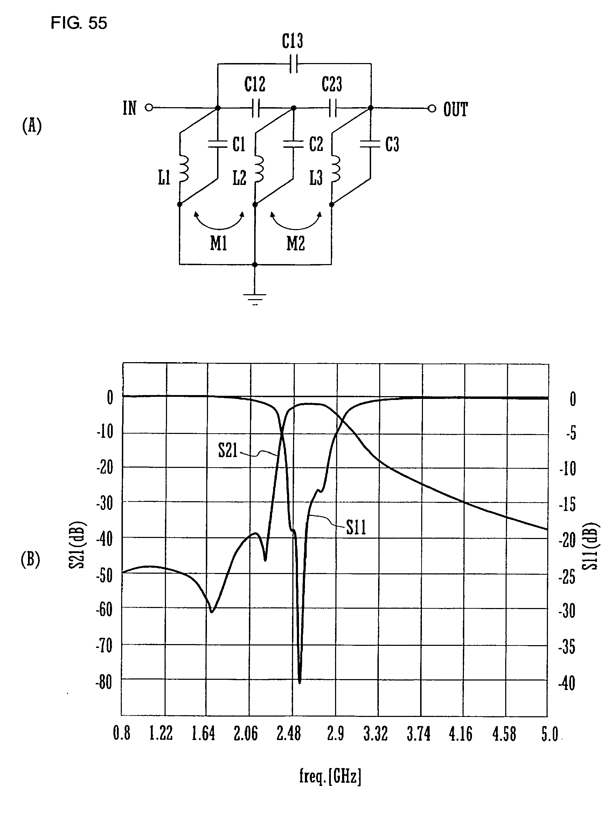

Fig. 54 is an exploded perspective view of a multilayer bandpass filter according to a twenty-second embodiment. Fig. 55(A) is an equivalent circuit diagram of the multilayer bandpass filter. Fig. 55(B) illustrates the bandpass characteristic and the reflection characteristic of the multilayer bandpass filter.

The multilayer bandpass filter has a laminated body including a ground electrode formation layer 901, a capacitor electrode forming layer 902, an input and output electrode forming layer 903, a line electrode forming layer 904, and an outer layer 905. Predetermined input and output terminals and ground terminal are provided on the end surfaces of the laminated body. This multilayer bandpass filter has an appearance similar to that shown in Fig. 2(B).

As shown in Fig. 54, input and output electrodes 1021 and 1022 and an input-output intermediate capacitor electrode 1060 are formed on the input and output electrode forming layer 903. The input-output intermediate capacitor electrode 1060 causes a capacitance to be formed between itself and each of the two input and output electrodes 1021 and 1022. Thus, capacitive coupling is achieved between the input and output electrodes 1021 and 1022.

Each of capacitor electrodes 1011, 1012, and 1013 formed on the capacitor electrode forming layer 902 faces a ground electrode 1009.

A via electrode 1031 is conductively coupled with the input and output electrodes 1021, the capacitor electrode 1011, a line electrode 1016. A via electrode 1035 is conductively coupled with the input and output electrode 1022, the capacitor electrode 1013, and a line electrode 1018.

A via electrode 1032 is conductively coupled with the other end of the line electrode 1016 and the ground electrode 1009. A via electrode 1033 is conductively coupled with the ground electrode 1009 and one end of a line electrode 1017. A via electrode 1034 is conductively coupled with the other end of the line electrode 1017 and the capacitor electrode 1012. A via electrode 1036 is conductively coupled with the other end of the line electrode 1018 and the ground electrode 1009.

An equivalent circuit diagram of this multilayer bandpass filter is shown in Fig. 55(A). This circuit is similar to that shown in Fig. 43(A) according to the sixteenth embodiment. Capacitors C1, C2, and C3 shown in Fig. 55(A) are formed by the capacitor electrodes 1011, 1012, and 1013 and the ground electrode 1009, respectively. An inductor L1 is formed by the line electrode 1016 and the via electrodes 1031 and 1032. An inductor L2 is formed by the line electrode 1017 and the via electrodes 1033 and 1034. An inductor L3 is formed by the line electrode 1018 and the via electrodes 1035 and 1036. A capacitor C12 is formed by an electrode-electrode gap between the capacitor electrodes 1011 and 1012. A capacitor C23 is formed by an electrode-electrode gap between the capacitor electrodes 1012 and 1013. A capacitor C13 is a capacitor having the total capacitance including capacitances formed in electrode-electrode gaps between the input-output intermediate capacitor electrode 1060 and the input and output electrodes 1021 and between the input-output intermediate capacitor electrode 1060 and the input and output electrode 1022, a capacitance formed between one end of the input-output intermediate capacitor electrode 1060 and the capacitor electrodes 1011, and a capacitance formed between the other end of the input-output intermediate capacitor electrode 1060 and the capacitor electrode 1013. In addition, inductive coupling M1 is achieved between the inductors L1 and L2, and inductive coupling M2 is achieved between the inductors L2 and L3. The polarity sequence of coupling between the three-stage LC parallel resonators is <101>.

The above-described structure functions as a bandpass filter including three-stage LC parallel resonators.

In the twenty-second embodiment, the middle line electrode 1017 of the three line electrodes 1016, 1017, and 1018 has a meandering shape. Accordingly, a relatively long line electrode can be formed in a limited area. Therefore, an area required for obtaining necessary inductance can be reduced, and thus, the overall size can be reduced.

In addition, the capacitor electrode 1012 of the second-stage LC parallel resonator formed on the capacitor electrode forming layer 902 is disposed at a location which is not between the capacitor electrode 1011 of the LC parallel resonator on the input side and the capacitor electrode 1013 of the LC parallel resonator on the output side.

The above-described arrangement of the capacitor electrodes enables independent setting of the capacitance between the two capacitor electrodes 1011 and 1013 to an optimum value while maintaining the capacitance between the capacitor electrodes 1011 and 1012 and the capacitance between the capacitor electrode 1013 and 1012 at small values. Accordingly, the capacitance between the input terminal and the output terminal can be set simply by adjusting the distance between the two capacitor electrodes 1011 and 1013, and therefore, the frequencies of attenuation poles appearing on either side of the passband can be easily designed. In contrast, in the example shown in Fig. 42, since the capacitor electrode 312 of the second-stage resonator is disposed between the capacitor electrodes 311 and 313, a relatively large capacitance is formed between the capacitor electrode 312 and each of the capacitor electrodes 311 and 313. As a result, it is difficult to design the value of the capacitance between the input terminal and the output terminal, and it is difficult to control the attenuation pole by using jumping coupling.

Furthermore, in the twenty-second embodiment, the input-output intermediate capacitor electrode 1060 is disposed at a location that does not face the capacitor electrode 1012 of the second-stage LC parallel resonator (i.e., a location at which the input-output intermediate capacitor electrode 1060 is not capacitively coupled with the capacitor electrode 1012). Thus, undesirable coupling between the input-output intermediate capacitor electrode 1060 and the capacitor electrode 1012 of the second-stage LC parallel resonator can be prevented, and therefore, a desirable attenuation characteristic can be obtained by using jumping coupling between the first-stage resonator and the third-stage resonator.

As described above, by sequentially coupling the three resonators such that their coupling polarities are set so as to have a polarity sequence of <101> and by capacitively coupling the first-stage resonator with the third-stage resonator, the characteristic shown in Fig. 55(B) can be obtained. In Fig. 55(B), a characteristic S21 represents a bandpass characteristic, and a characteristic S11 represents a reflection characteristic. In this example, a passband ranging from about 2.3 GHz to about 2.9 GHz can be obtained. In addition, two attenuation poles appear on a lower side of the passband. As can be seen from a comparison with Fig. 43(B), of the two attenuation poles appearing on the lower side of the passband, an attenuation pole closer to the passband provides large attenuation on the lower range of the passband. More specifically, attenuation of about -40 dB can be obtained in the frequency range lower than about 2.2 GHz.

### Twenty-Third Embodiment

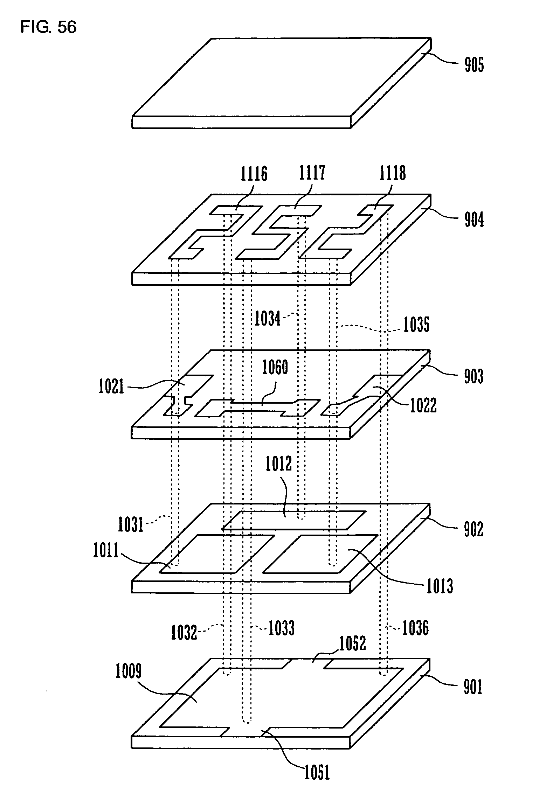

Fig. 56 is an exploded perspective view of a multilayer bandpass filter according to a twenty-third embodiment. In the twenty-third embodiment, the line electrode pattern formed on a line electrode forming layer 904 is different from that in the example shown in Fig. 54 according to the twenty-second embodiment. In the example shown in Fig. 56, line electrodes 1116, 1117, and 1118 having a meandering shape are arranged on the line electrode forming layer 904. The other structures are similar to those shown in Fig. 54. Accordingly, an equivalent circuit of the multilayer bandpass filter is similar to that shown in Fig. 55(A).

The line electrode pattern is determined so as to be point-symmetrical with respect to the center of the line electrode forming layer 904. This symmetrical pattern allows an inductor L1 of a first-stage LC parallel resonator and an inductor L3 of a third-stage LC parallel resonator in the equivalent circuit to have substantially the same inductance, and inductive coupling M1 between the inductors L1 and L2 and inductive coupling M2 between the inductors L2 and L3 to be substantially the same.

While the present embodiment has been described with reference to the line electrodes 1116, 1117, and 1118 each having a meandering shape, the first-stage line electrode 1116 and the third-stage line electrode 1118 may have a U shape that protrudes to the center side.

Since the lengths of the line electrodes 1116, 1117, and 1118 are increased, the inductance of the inductors L1, L2, and L3 of the LC parallel resonators in the equivalent circuit is increased. Thus, the passband can be set in a lower frequency range, as compared with the configuration in which the line electrodes 1116, 1117, and 1118 have a shape of a straight line.

In this way, a compact multilayer bandpass filter can be achieved. In addition, by changing only the line electrode forming layer 904, the filter characteristics can be easily changed.

### Twenty-Fourth Embodiment

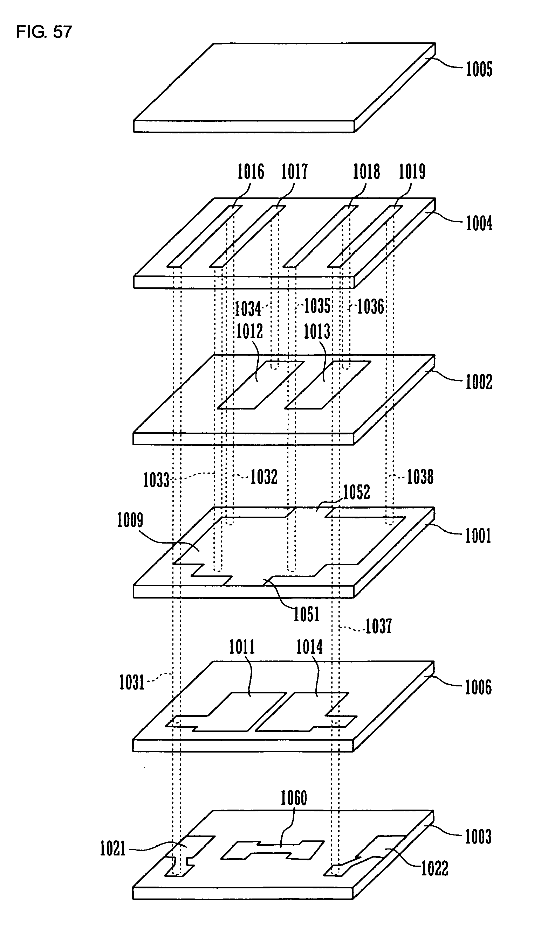

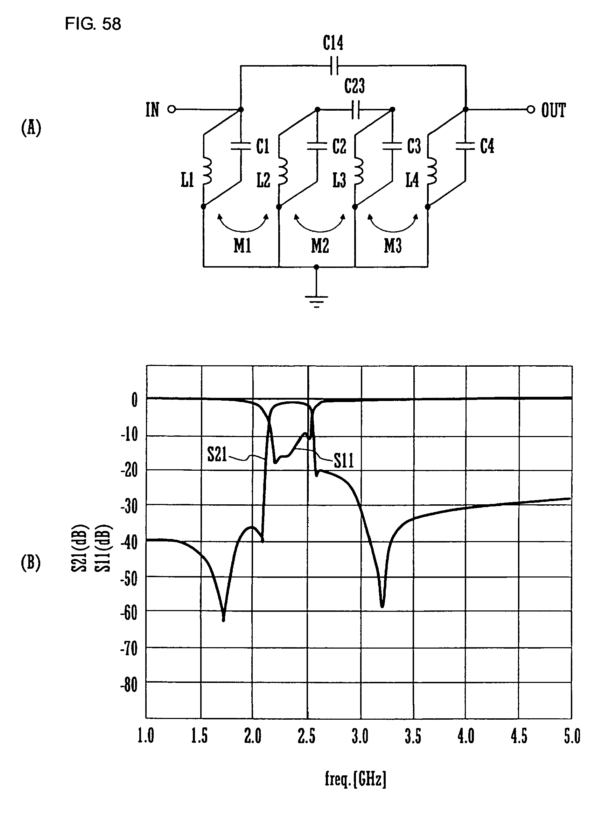

Fig. 57 is an exploded perspective view of a multilayer bandpass filter according to a twenty-fourth embodiment. Fig. 58(A) is an equivalent circuit diagram of the multilayer bandpass filter. Fig. 58(B) illustrates a bandpass characteristic and a reflection characteristic of the multilayer bandpass filter.

The multilayer bandpass filter has a laminated body including a ground electrode forming layer 1001, capacitor electrode forming layers 1002 and 1006, an input and output electrode forming layer 1003, a line electrode forming layer 1004, and an outer layer 1005. Predetermined input and output terminal and ground terminal are provided on the end surfaces of the laminated body. The appearance of this multilayer bandpass filter is similar to that shown in Fig. 2(B).

As shown in Fig. 57, input and output electrodes 1021 and 1022 and an input-output intermediate capacitor electrode 1060 are formed on the input and output electrode forming layer 1003. The input-output intermediate capacitor electrode 1060 produces a capacitance between itself and the input and output electrode 1011 and a capacitance between itself and the input and output electrode 1014 so as to achieve capacitive coupling between the input and output electrodes 1021 and 1022.

The capacitor electrodes 1011 and 1014 disposed on the capacitor electrode forming layer 1006 face the ground electrode 1009.

Capacitor electrodes 1012 and 1013 disposed on the capacitor electrode forming layer 1002 face the ground electrode 1009.

A via electrode 1031 is conductively coupled with the input and output electrode 1021, the capacitor electrode 1011, and one end of a line electrode 1016. A via electrode 1032 is conductively coupled with the other end of the line electrode 1016 and a ground electrode 1009. A via electrode 1033 is conductively coupled with the ground electrode 1009 and one end of a line electrode 1017. A via electrode 1034 is conductively coupled with the other end of the line electrode 1017 and the capacitor electrode 1012. A via electrode 1035 is conductively coupled with one end of a line electrode 1018 and the ground electrode 1019. A via electrode 1036 is conductively coupled with the other end of the line electrode 1018 and the capacitor electrode 1013. A via electrode 1037 is conductively coupled with the input and output electrode 1022, the capacitor electrode 1014, and the line electrode 1019. A via electrode 1038 is conductively coupled with the other end of the line electrode 1019 and the ground electrode 1009.

The equivalent circuit diagram of the multilayer bandpass filter is shown in Fig. 58(A). In Fig. 58(A), capacitors C1, C2, C3, and C4 are capacitors having capacitances formed between the capacitor electrodes 1011, 1012, 1013, and 1014 and the ground electrode 1009, respectively. An inductor L1 is an inductor having inductance formed by the line electrode 1016 and the via electrodes 1031 and 1032. An inductor L2 is an inductor having inductance formed by the line electrode 1017 and the via electrodes 1033 and 1034. An inductor L3 is an inductor having inductance formed by the line electrode 1018 and the via electrodes 1035 and 1036. An inductor L4 is an inductor having inductance formed by the line electrode 1019 and the via electrodes 1037 and 1038.

A capacitor C23 is a capacitor having a capacitance formed in an electrode-electrode gap between the capacitor electrode 1012 and the capacitor electrode 1013. A capacitor C14 is a capacitor having the total capacitance including capacitances formed in electrode-electrode gaps between the input-output intermediate capacitor electrode 1060 and the input and output electrodes 1011 and between the input-output intermediate capacitor electrode 1060 and the input and output electrode 1014, a capacitance between one end of the input-output intermediate capacitor electrode 1060 and the capacitor electrodes 1011, and a capacitance between the other end of the input-output intermediate capacitor electrode 1060 and the capacitor electrode 1014.

In addition, inductive coupling M1 is achieved between the inductors L1 and L2, inductive coupling M2 is achieved between the inductors L2 and L3, and inductive coupling M3 is achieved between the inductors L3 and L4. The polarity sequence of coupling between the four-stage LC parallel resonators is <1001>.

The above-described structure provides a bandpass filter including four-stage LC parallel resonators.

In the twenty-fourth embodiment, since the capacitor electrodes 1011 and 1014 of the resonators located on the input side and the output side, respectively, are provided in an electrode layer different from an electrode layer of the capacitor electrodes 1012 and 1013 of the other resonators, the capacitors 1011 and 1014 of the resonators at the input and output sides are not coupled with the capacitor electrodes 1012 and the 1013 of the other resonators, and therefore, a stable capacitance can be obtained. As a result, the attenuation pole characteristic and filter characteristic are improved.

In addition, the capacitor electrodes 1011 and 1014 of the resonators at the input and output sides are not electromagnetically coupled with inductors of resonators, and thus, the resonators have high Q values. As a result, the attenuation pole characteristic and filter characteristic are improved.

Furthermore, since the capacitor electrodes 1011 and 1014 of the resonators at the input and output sides are disposed on one side of the internal ground electrode 1009, and the other capacitor electrodes 1012 and 1013 are disposed on the other side of the ground electrode 1009, the effective area of the internal ground electrode can be increased. As a result, a filter having a small size can be designed.

Fig. 58(B) is a characteristic diagram of the multilayer bandpass filter according to the twenty-fourth embodiment. In this diagram, a characteristic S21 represents a bandpass characteristic, and a characteristic S11 represents a reflection characteristic. In this example, a passband ranging from about 2.2 GHz to about 2.5 GHz is obtained. Two attenuation poles appear in lower and higher ranges of the passband. As can be seen from a comparison with Fig. 46(B), of the two attenuation poles appearing in the higher range adjacent to the passband, an attenuation pole in the higher range closer to the passband can provide large attenuation.

### Twenty-Fifth Embodiment

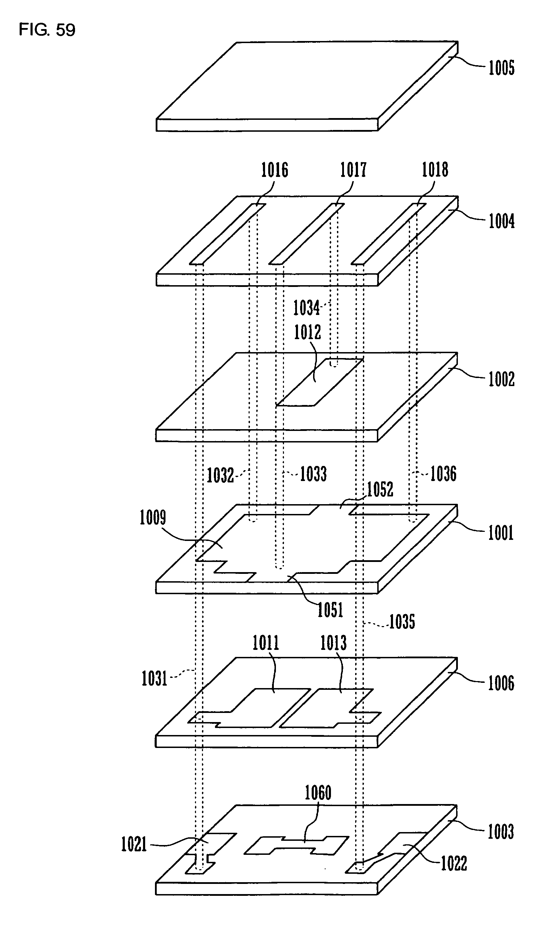

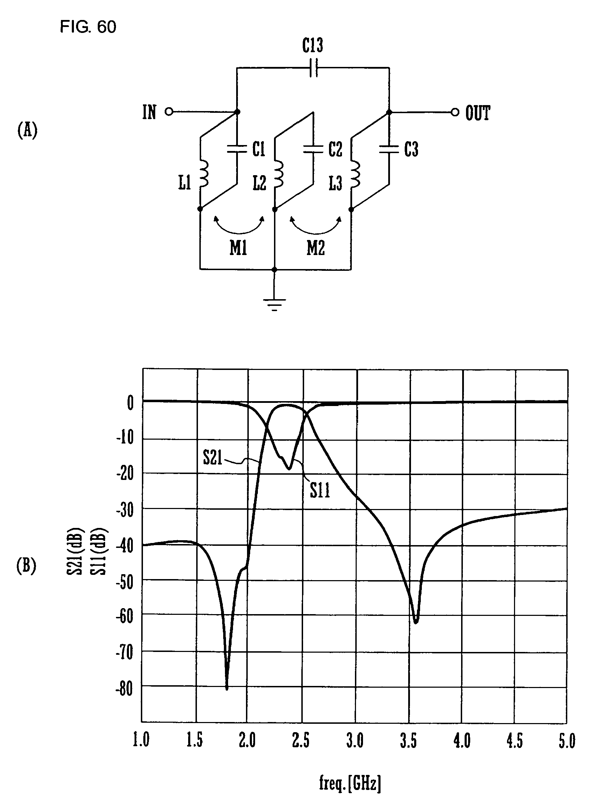

Fig. 59 is an exploded perspective view of a multilayer bandpass filter according to a twenty-fifth embodiment. Fig. 60(A) is an equivalent circuit diagram of the multilayer bandpass filter. Fig. 60(B) illustrates a bandpass characteristic and a reflection characteristic of the multilayer bandpass filter.

Unlike the twenty-fourth embodiment having four-stage resonators, the twenty-fifth embodiment employs three-stage resonators.

The multilayer bandpass filter has a laminated body including a ground electrode forming layer 1001, capacitor electrode forming layers 1002 and 1006, an input and output electrode forming layer 1003, a line electrode forming layer 1004, and an outer layer 1005. Predetermined input and output terminal and ground terminal are provided on the end surfaces of the laminated body. The appearance of this multilayer bandpass filter is similar to that shown in Fig. 2(B).

As shown in Fig. 59, three line electrode 1016, 1017, and 1018 are formed on the line electrode forming layer 1004. A capacitor electrode 1012 is formed on the capacitor electrode forming layer 1002. In accordance with shapes and locations of these electrodes, locations of via electrodes are determined. The other electrode layers are arranged in a similar manner to those shown in Fig. 57. That is, the electrodes are arranged so as to have an electrode pattern similar to that of the four-stage resonators shown in Fig. 57.

A via electrode 1031 is conductively coupled with an input and output electrode 1021, a capacitor electrode 1011, and one end of the line electrode 1016. A via electrode 1032 is conductively coupled with the other end of the line electrode 1016 and a ground electrode 1009. A via electrode 1033 is conductively coupled with the ground electrode 1009 and one end of the line electrode 1017. A via electrode 1034 is conductively coupled with the other end of the line electrode 1017 and the capacitor electrode 1012. A via electrode 1035 is conductively coupled with an input and output electrode 1022, a capacitor electrode 1013, and one end of the line electrode 1018. A via electrode 1036 is conductively coupled with the other end of the line electrode 1018 and the ground electrode 1009.

The equivalent circuit diagram of the multilayer bandpass filter is shown in Fig. 60(A). In this equivalent circuit shown in Fig. 60(A), capacitors C1, C2, and C3 are capacitors having capacitances formed between the capacitor electrodes 1011, 1012, and 1013 and the ground electrode 1009, respectively. An inductor L1 is formed by the line electrode 1016 and the via electrodes 1031 and 1032. An inductor L2 is formed by the line electrode 1017 and the via electrodes 1033 and 1034. An inductor L3 is formed by the line electrode 1018 and the via electrodes 1035 and 1036.

A capacitor C13 is a capacitor having the total capacitance including capacitances formed between an input-output intermediate capacitor electrode 1060 and the input and output electrodes 1011 and between the input-output intermediate capacitor electrode 1060 and the input and output electrode 1013, a capacitance between one end of the input-output intermediate capacitor electrode 1060 and the capacitor electrodes 1011, and a capacitance between the other end of the input-output intermediate capacitor electrode 1060 and the capacitor electrode 1013.

In addition, inductive coupling M1 is achieved between the inductors L1 and L2, and inductive coupling M2 is achieved between the inductors L2 and L3. The polarity sequence of coupling between the three-stage LC parallel resonators is <101>.

The above-described structure provides a bandpass filter including three-stage LC parallel resonators.

In the twenty-fifth embodiment, the capacitor electrodes 1011 and 1013 of the resonators located on the input side and the output side, respectively, are formed on an electrode layer different from an electrode layer of the capacitor electrode 1012 of the other resonator. Accordingly, the capacitors 1011 and 1013 of the resonators at the input and output sides are not coupled with the capacitor electrode 1012 of the other resonator, and thus, a stable capacitance can be obtained. As a result, the attenuation pole characteristics and filter characteristics are improved.

Furthermore, the capacitor electrodes 1011 and 1013 of the resonators on the input and output sides are not electromagnetically coupled with inductors of resonators, and thus, the resonators having a high-Q characteristic can be achieved. As a result, the attenuation pole characteristics and filter characteristics are improved.

Furthermore, since the capacitor electrodes 1011 and 1013 of the resonators at the input and output sides are disposed on one side of the internal ground electrode 1009, and the other capacitor electrode 1012 is disposed on the other side of the ground electrode 1009, the effective area of the internal ground electrode can be increased. As a result, a filter having a small size can be designed.

Fig. 60(B) is a characteristics diagram of the multilayer bandpass filter according to the twenty-fifth embodiment. In this diagram, a characteristic S21 represents a bandpass characteristic, and a characteristic S11 represents a reflection characteristic. In this example, a passband ranging from about 2.2 GHz to about 2.5 GHz is obtained. In addition, two attenuation poles appear in a lower frequency side of the passband, and one attenuation pole appears in a higher frequency side of the passband. As can be seen from a comparison with Fig. 43(B), of the two attenuation poles appearing on the lower side, the attenuation pole closer to the passband can provide large attenuation.

## Claims

1. A multilayer bandpass filter comprising:
a laminated body including a plurality of dielectric layers and a plurality of electrode layers each including at least one of a capacitor electrode and an inductor electrode, at least three LC parallel resonators being formed by the capacitor electrodes and the inductor electrodes, pairs of the neighboring LC parallel resonators being coupled;
an input electrode for allowing the LC parallel resonator disposed on an input side among the plurality of LC parallel resonators to be connected thereto; and
an output electrode for allowing the LC parallel resonator disposed on an output side among the plurality of LC parallel resonators to be connected thereto;
wherein the inductor electrode of each of the plurality of LC parallel resonators forms a loop starting from a connection point between an end of the inductor electrode and the capacitor electrode, planes of the loops formed by the inductor electrodes of the coupled LC parallel resonators at least partially overlap when viewed from a direction in which the inductor electrodes are arranged, and loop directions of the inductor electrodes of the at least two coupled LC parallel resonators are opposite when viewed from a direction in which the inductor electrodes are arranged.

2. The multilayer bandpass filter according to Claim 1, wherein the direction of the loop of the inductor electrode of the LC parallel resonator on the input side is opposite to the direction of the loop of the inductor electrode of the LC parallel resonator adjacent to the inductor electrode of the LC parallel resonator on the input side, and the direction of the loop of the inductor electrode of the LC parallel resonator on the output side is opposite to the direction of the loop of the inductor electrode of the LC parallel resonator adjacent to the inductor electrode of the LC parallel resonator on the output side.

3. The multilayer bandpass filter according to Claim 1 or 2, wherein at least one of the plurality of LC parallel resonators includes a plurality of inductor electrodes.

4. The multilayer bandpass filter according to any one of Claims 1 to 3, further comprising:
a traverse electrode electrically isolated from the inductor electrodes of the plurality of LC parallel resonators and extending across the inductor electrodes of the plurality of LC parallel resonators.

5. The multilayer bandpass filter according to Claim 4, wherein the traverse electrode is conductively coupled with a ground electrode provided on a ground side of the LC parallel resonators.

6. The multilayer bandpass filter according to any one of Claims 1 to 5, further comprising:
a side electrode provided on a side surface of the plurality of stacked dielectric layers;
wherein a ground electrode provided on a ground side of the LC parallel resonators is conductively coupled with the side electrode via at least one connection electrode.

7. The multilayer bandpass filter according to Claim 5 or 6, wherein the ground electrode includes a plurality of sub ground electrodes each used for predetermined ones of the plurality of LC parallel resonators, and the plurality of sub ground electrodes are electrically isolated from each other at high frequencies.

8. The multilayer bandpass filter according to any one of Claims 1 to 7, wherein the inductor electrode of each of the plurality of LC parallel resonators has the shape of a coil formed by a via electrode extending in a direction in which the dielectric layers are stacked and at least a line electrode extending in a direction that is perpendicular to the direction in which the dielectric layers are stacked, and the inductor electrodes and the capacitor electrodes are arranged in a direction that is perpendicular to the direction in which the dielectric layers and the electrode layers are stacked.

9. The multilayer bandpass filter according to Claim 8, wherein an input and output electrode forming layer having the input electrode and the output electrode thereon is disposed separately from an electrode layer including at least one of the capacitor electrode and the line electrode of electrodes, and the input terminal and the output terminal conductively coupled with the input electrode and the output electrode, respectively, are disposed on side surfaces of the laminated body.

10. The multilayer bandpass filter according to Claim 9, wherein the input and output electrode forming layer is disposed between the electrode layer having the line electrodes formed therein and the electrode layer having the capacitor electrodes formed therein.

11. The multilayer bandpass filter according to any one of Claims 1 to 10, wherein the capacitor electrode of each of the plurality of LC parallel resonators is formed by a chip capacitor mounted on a surface of the laminated body.

12. The multilayer bandpass filter according to any one of Claims 8 to 10, wherein the capacitor electrode of each of the plurality of LC parallel resonators produces a capacitance between the capacitor electrode and a common ground electrode extending over a region in which the capacitor electrodes of the plurality of LC parallel resonators are located, and the capacitor electrodes are disposed in the same electrode layer.

13. The multilayer bandpass filter according to any one of Claims 8 to 12, wherein the line electrodes are disposed in the same electrode layer.

14. The multilayer bandpass filter according to Claim 13, wherein the capacitor electrodes and the line electrodes are arranged so as to be line-symmetrical with respect to an imaginary center line passing through the center of an area where the capacitor electrodes and the line electrodes are distributed and extending parallel to the line electrodes.

15. The multilayer bandpass filter according to Claim 13 or 14, wherein at least two neighboring line electrodes have different widths from each other.

16. The multilayer bandpass filter according to any one of Claims 13 to 15, wherein the distances between pairs of neighboring line electrodes are uneven in a width direction of the line electrodes.

17. The multilayer bandpass filter according to any one of Claims 8 to 16, wherein two via electrodes are connected to each of the line electrodes, and the distances between two connection points of at least two of the line electrodes are different.

18. The multilayer bandpass filter according to any one of Claims 8 to 17, wherein a capacitor electrode that capacitively couples the input electrode with the output electrode is disposed in a predetermined one of the plurality of electrode layers.

19. The multilayer bandpass filter according to any one of Claims 8 to 18, wherein at least one of the line electrodes has one of a meandering shape and a U shape.

20. The multilayer bandpass filter according to any one of Claims 8 to 19, wherein the capacitor electrodes other than the capacitor electrodes of the LC parallel resonators on the input and output sides are formed in an area other than an area located between the capacitor electrodes of the LC parallel resonators on the input and output sides.

21. The multilayer bandpass filter according to any one of Claims 8 to 20, wherein the capacitor electrodes of the LC parallel resonators on the input side and the output side are provided in an electrode layer different from an electrode layer in which the other capacitor electrodes are formed.

22. The multilayer bandpass filter according to any one of Claims 13 to 21, wherein the line electrodes are formed from chip inductors mounted on the surface of the laminated body.

23. The multilayer bandpass filter according to any one of Claims 8 to 10 and Claims 12 to 22, wherein the dielectric layer stacked on the electrode layer including the line electrodes has a relative permittivity greater than or equal to 6 and less than or equal to 80, and the dielectric layer having the electrode layer including the capacitor electrodes thereon has a relative permittivity greater than or equal to 20.

24. The multilayer bandpass filter according to any one of Claims 1 to 23, wherein the dielectric layers are formed from low temperature co-fired ceramic.
